# EUROPÄISCHE PATENTSCHRIFT

(11) **EP 1 553 422 B1**
(45) Veröffentlichungstag und Bekanntmachung des Hinweises auf die Patenterteilung: **10.03.2010**
(21) Anmeldenummer: 04031077.3
(22) Anmeldetag: 31.12.2004
(51) Int. Cl.: G01R 31/02, H04B 3/46, B60R 16/02

(54) **Elektrisches Versorgungsnetzwerk mit Kurzschluss- und Unterbrechungsdetektion für Bordnetze von Kraftfahrzeugen**
Electric supply system including short-circuit and interrupt detection for vehicle power systems
Système de alimentation électrique avec détection de court-circuit et d'interruption pour des réseaux de bord des véhicules

(30) Priorität: 09.01.2004 DE 102004001403; 13.08.2004 DE 102004041008
(43) Veröffentlichungstag der Anmeldung: 13.07.2005
(73) Patentinhaber: Stribel Production GmbH, 72636 Frickenhausen (DE)
(72) Erfinder: Flock, Horst, 72766 Reutlingen (DE); Kanamüller, Thomas, 73732 Esslingen (DE); Ehrhardt, Jörg, 72622 Nürtingen (DE)
(74) Vertreter: Rupprecht, Kay

(56) Entgegenhaltungen:
- EP-A- 0 812 049
- EP-A- 1 286 429
- WO-A-03/032445
- DE-A1- 3 731 537
- US-A- 6 049 139

## Beschreibung

Die Erfindung betrifft ein elektrisches Versorgungsnetzwerk für Bordnetze von Fahrzeugen aller Art, das heißt Land-, Luft- und Wasserfahrzeugen, insbesondere für Bordnetze von Kraftfahrzeugen, umfassend mindestens ein Netzwerksystem mit einem Stromeinspeiseanschluß, mit mindestens einem Verbraucheranschluß und mit einem von dem Stromeinspeiseanschluß zu dem mindestens einen Verbraucheranschluß geführten Versorgungsleitungssystem, welches mindestens einen stromführenden Leitungsstrang und mindestens einen diesen umgebenden Schutzmantel aufweist.

Derartige Versorgungsnetzwerke sind aus der Fahrzeugtechnik bekannt.

Wird jedoch das Versorgungsleitungssystem mit Spannungen betrieben, die über 12 Volt, vorzugsweise über 20 Volt, üblicherweise oft sogar über 30 Volt, liegen, so besteht ein latentes Gefahrenpotential dann, wenn der stromführende Leitungsstrang unterbrochen wird, beispielsweise durch eine unbeabsichtigte Trennung an einer lösbaren Verbindung oder durch einen Defekt oder wenn der Schutzmantel Schaden nimmt, da sich dann über den Defekt des stromführenden Leitungsstrangs hinweg oder, ausgehend von dem stromführenden Leitungsstrang zu einem beliebigen Teil des Fahrzeugs, insbesondere zu einem auf Masse liegenden Teil des Fahrzeugs, jeweils ein Lichtbogen ausbilden kann, welcher aufgrund der üblicherweise zur Verfügung stehenden Stromstärken eine erhebliche Brandgefahr darstellt.

Der Erfindung liegt daher die Aufgabe zugrunde, eine Leitungsanordnung der gattungsgemäßen Art derart zu verbessern, daß ein Lichtbogen entweder vermieden oder bei Ausbildung eines Lichtbogens dieser möglichst rasch wieder beendet werden kann.

Das Dokument US 6 049 139 A (Nagaura) offenbart eine Überwachung eines Signals auf einem Detektorleitungssystem ohne dass dabei eine Veränderung der elektrischen

Eigenschaften dieses Detektorleitungssystems ausgewertet wird.

Die Patentanmeldung DE 37 31 537 A1 (Siemens) offenbart ein System, das durch gezielte Einstellung eines Spannungsteilers, der auch durch den Widerstand einer Abschirmung beeinflusst wird, die Art der Störung anhand der Veränderung von am Spannungsteiler abfallenden Spannungen erfassen kann.

Die europäische Patentanmeldung EP 0 812 049 A (Hitachi) beschreibt ein Fahrzeugbordnetz in Ringtopologie, wobei die Ringleitung durch eine Abschirmung geschützt wird. Beschädigungen der Leitungen werden als Potentialveränderungen erfasst und führen zur Abschaltung. Eine Veränderung der elektrischen Eigenschaften wird nicht erfasst; vielmehr wird eine Potentialänderung der Messspannungen durch den unerwünschten Kontakt mit einem Leiter auf anderem Potential ausgewertet.

Diese Aufgabe wird bei einem elektrischen Versorgungsnetzwerk der eingangs beschriebenen Art erfindungsgemäß dadurch gelöst, daß das Versorgungsleitungssystem mit einem Detektorleitungssystem versehen ist, welches an einem ersten Ende mit einer Detektorschaltung verbunden ist und an mindestens einem weiteren Ende mit einem Abschlußelement verbunden ist, daß die Detektorschaltung ein Prüfsignal erzeugt, welches im defektfreien Zustand durch die Detektorleitung und das Abschlußelement beeinflußt ist, und daß die Detektorschaltung einen Defekt durch Abweichung des Prüfsignals von einem dem defektfreien Zustand entsprechenden Sollwertbereich erfaßt.

Der Vorteil der erfindungsgemäßen Lösung ist darin zu sehen, daß mit dieser die Möglichkeit besteht, den defektfreien Zustand des Versorgungsleitungssystems nicht nur über den Einfluß des Detektorleitungssystems auf das Prüfsignal zu überprüfen, sondern auch gleichzeitig über den Einfluß des Abschlußelements, welches an einem der Detektorschaltung abgewandt liegenden Ende des Detektorleitungssystems angeordnet ist und einen definierten Einfluß auf das Prüfsignal ausübt.

Die Detektorschaltung könnte prinzipiell so ausgebildet sein, daß diese beim Erfassen eines Defekts lediglich eine Defektmeldung gibt.

Aus Gründen einer optimalen Sicherheit ist vorzugsweise vorgesehen, daß die Detektorschaltung beim Erfassen eines Defekts ein Trennen des Versorgungsleitungssystems von der Stromquelle auslöst.

Ein derartiges Trennen kann in unterschiedlichster Art und Weise entweder direkt oder indirekt realisierbar sein.

Beispielsweise wäre über ein fahrzeugeigenes Datenbussystem oder über ein weiteres zwischengeschaltetes Sicherheitssystem eine derartige Trennung durchführbar.

Eine besonders sichere Lösung sieht vor, daß die Detektorschaltung eine Trennschaltung zum Abtrennen des Versorgungsleitungssystems von der Stromquelle ansteuert, das heißt, daß eine unmittelbare Ansteuerung der Trennschaltung ohne gegebenenfalls weitere dazwischengeschaltete Sicherheitssysteme erfolgt.

Im Zusammenhang mit der bislang beschriebenen Lösung wird darauf abgestellt, daß mindestens ein weiteres Ende des Detektorleitungssystems mit einem Abschlußelement versehen ist.

Insbesondere beim Vorsehen mehrerer weiterer Enden des Detektorleitungssystems ist zweckmäßigerweise an jedem der weiteren Enden ein Abschlußelement vorgesehen, um das Detektorleitungssystem insoweit zu überwachen, daß in dem zu dem jeweiligen Ende führenden Abschnitt des Detektorleitungssystems jeweils eine Unterbrechung des Detektorleitungssystems erfaßbar ist.

Um den stromführenden Leitungsstrang im wesentlichen vollständig zu überwachen, ist vorzugsweise vorgesehen, daß das Detektorleitungssystem gegenüber dem stromführenden Leitungsstrang elektrisch isoliert verläuft und dem Leitungsstrang im wesentlichen folgt, so daß sich von dem Leitungsstrang ausgehend ausbreitende Lichtbogen über das Detektorleitungssystem erfaßbar sind.

Insbesondere ist dabei das Detektorleitungssystem so ausgebildet, daß es beim Auftreten eines vom stromführenden Leitungsstrang ausgehenden lokalen Lichtbogens seine elektrischen Eigenschaften irreversibel verändert.

Besonders vorteilhaft läßt sich der stromführende Leitungsstrang dann überwachen, wenn das Detektorleitungssystem längs des stromführenden Leitungsstrangs verläuft.

Besonders vorteilhaft läßt sich der stromführende Leitungsstrang dann überwachen, wenn das Detektorleitungssystem im wesentlichen um den stromführenden Leitungsstrang herum verläuft.

Hinsichtlich der Dimensionierung des Abschlußelements wurden im Zusammenhang mit den bisherigen Ausführungen keine näheren Angaben gemacht. Es wurde lediglich gefordert, daß das Abschlußelement das Prüfsignal beeinflussen soll, so daß eine Überbrückung des Abschlußelements, beispielsweise durch einen Kurzschluß, über eine Sollwertabweichung des Prüfsignals erfaßbar ist.

Besonders vorteilhaft ist es, wenn im defektfreien Zustand das Abschlußelement das Prüfsignal in einem stärkeren Maß beeinflußt als das Detektorleitungssystem, so daß das Prüfsignal primär durch das Abschlußelement beeinflußt ist und somit dessen ungestörte Anwesenheit und somit die durchgehende Funktionsfähigkeit des Detektorleitungssystems sicher erkannt werden können.

Besonders günstig ist es wenn das Abschlußelement das Prüfsignal um mindestens einen Faktor 10 stärker beeinflußt als das Detektorleitungssystem.

Noch besser ist es, wenn das Abschlußelement das Prüfsignal um mindestens einen Faktor 50, noch besser einen Faktor 100 stärker beeinflußt als das Detektorleitungssystem.

Im einfachsten Fall ist dabei das Abschlußelement so ausgebildet, daß es einen elektrischen Widerstand umfaßt, welcher durch seine elektrischen Eigenschaften das Prüfsignal beeinflußt.

Unter einem derartigen elektrischen Widerstand ist nicht nur ein Ohm'scher Widerstand, sondern jede Art von elektrischem Widerstand, also sowohl ein Ohm'scher als auch ein kapazitiver oder ein induktiver oder eine Kombination aller dieser Möglichkeiten zu verstehen.

Um zusätzlich über das Abschlußelement noch weitere Defektmeldungen generieren zu können, ist vorzugsweise vorgesehen, daß das Abschlußelement einen elektrischen Schalter umfaßt.

Ein derartiger elektrischer Schalter eröffnet die Möglichkeit, ergänzend zur Überwachung des Detektorleitungssystems über das Detektorleitungssystem noch weitere Defektzustände der Detektorschaltung zu melden.

Eine vorteilhafte Möglichkeit sieht vor, daß der elektrische Schalter ein Zustandsanzeiger für Defekte einer Verbindung des Versorgungsleitungssystems zu nachfolgenden Einheiten darstellt.

Derartige nachfolgende Einheiten können beispielsweise Verbraucher oder andere elektrische Einheiten oder auch weitere Netzwerksysteme sein.

Im einfachsten Fall ist dabei vorgesehen, daß der elektrische Schalter mechanisch steuerbar ist und somit beispielsweise die Möglichkeit eröffnet, eine mechanische Verbindung zu einer nachfolgenden Einheit, beispielsweise eine Steckverbindung, zu überprüfen.

Eine andere vorteilhafte Möglichkeit sieht vor, daß der elektrische Schalter elektrisch steuerbar ist und somit die Möglichkeit besteht, elektrisch erfaßbare Zustände bei den nachfolgenden Einheiten zu erfassen.

Eine günstige Lösung sieht vor, die der nachfolgenden Einheit über den stromführenden Leitungsstrang zugeführte Spannung zu erfassen, um damit beispielsweise Defekte im Leitungsstrang selbst erkennen zu können.

Eine andere Möglichkeit ist, daß durch die elektrische Ansteuerung des Schalters über eine Detektorschaltung eines nachfolgenden Netzwerksystems dessen Defekte ebenfalls durch das vorausgehende Netzwerksystem erfaßbar sind.

Hinsichtlich der Generierung des Prüfsignals wurden im Zusammenhang mit den bisherigen Ausführungsbeispielen keine näheren Angaben gemacht.

Grundsätzlich kann das Prüfsignal in unterschiedlichster Weise generiert und von der Detektorschaltung in unterschiedlichster Weise ausgewertet werden.

Eine aufgrund ihrer Einfachheit besonders vorteilhafte Lösung sieht dabei vor, daß die Detektorschaltung mit dem Prüfsignal einen von dem Detektorleitungssystem dem Abschlußelement gebildeten elektrischen Widerstand erfaßt.

Der elektrische Widerstand könnte dabei beispielsweise im Rahmen einer geschlossenen Leitungsschleife erfaßt werden. Bei Bordnetzen von Fahrzeugen ist es jedoch aufgrund der Einfachheit besonders günstig, wenn die Detektorschaltung den elektrischen Widerstand gegen Masse detektiert.

Im einfachsten Fall ist somit das Abschlußelement zwischen dem zweiten Ende des Detektorleitungssystems und Masse liegend angeordnet.

Besonders einfach läßt sich bei der erfindungsgemäßen Lösung das Prüfsignal dann generieren, wenn dieses durch einen Spannungsteiler erzeugbar ist.

Vorzugsweise ist dabei der Spannungsteiler so ausgebildet, daß das Abschlußelement ein Element des Spannungsteilers ist.

Weiterhin ist es vorteilhaft, wenn das Detektorleitungssystem ein Element des Spannungsteilers ist.

Ferner ist zweckmäßigerweise vorgesehen, daß die Detektorschaltung einen von dem ersten Ende des Detektorleitungssystems zu einer Spannungsversorgung führenden ersten Zweig eines Spannungsteilers zur Erzeugung des Prüfsignals umfaßt.

Eine derartige Schaltung zur Generierung des Prüfsignals ist dabei besonders einfach realisierbar.

Ferner ist es günstig, wenn das Abschlußelement und das Detektorleitungssystem einen zweiten Zweig des Spannungsteilers bilden, so daß das Abschlußelement und das Detektorleitungssystem unmittelbar zur Festlegung des Prüfsignals beitragen und jede Veränderung im Bereich des Detektorleitungssystems oder des Abschlußelements im Sinne einer Unterbrechung oder eines Kurzschlusses das Prüfsignal signifikant verändert.

Besonders günstig ist es dabei, wenn der zweite Zweig des Spannungsteilers zwischen dem ersten Ende des Detektorleitungssystems und Masse liegt, um insbesondere jede Verbindung zwischen dem Detektorleitungssystem und Masse unmittelbar als signifikanten Einfluß auf das Prüfsignal erfassen zu können.

Bei einem derartigen Spannungsteiler ist es besonders günstig, wenn als Prüfsignal die Spannung am ersten Ende der Detektorleitung überwacht wird.

Besonders einfach läßt sich dies dann realisieren, wenn die Detektorschaltung mit einer Überwachungsschaltung ein Über- oder Unterschreiten von Spannungsschwellen umfaßt.

Besonders günstig ist es dabei, wenn die Detektorschaltung mit der Überwachungsschaltung die Spannung im Hinblick auf ein Überschreiten einer oberen Spannungsschwelle und ein Unterschreiten einer unteren Spannungsschwelle überwacht.

Hinsichtlich des Prüfsignals ist selbst bei Messung von Spannungen noch nicht festgelegt, ob dieses Gleichspannungen oder Wechselspannungen sein sollen.

Beide Möglichkeiten sind im Rahmen der erfindungsgemäßen Lösung denkbar.

So sieht eine erste Möglichkeit vor, daß das Prüfsignal ein Gleichspannungssignal ist, das einfach generierbar ist.

Ein derartiges Gleichspannungssignal ist im einfachsten Fall ein Gleichspannungssignal mit einem einzigen Gleichspannungspotential.

Es ist aber auch denkbar, daß das Prüfsignal mehrere Gleichspannungspotentiale umfaßt.

Beim Vorsehen mehrerer Gleichspannungspotentiale können diese vorzugsweise aufeinanderfolgend angelegt werden.

Eine derartige Folge von Gleichspannungssignal braucht nicht zwingenderweise mit einer bestimmten Periodendauer oder einer bestimmten Frequenz erfolgen. Es ist auch denkbar, derartige Gleichspannungspotentiale stochastisch aufeinanderfolgend anzulegen.

Besonders günstig ist es, wenn mindestens während eines Überwachungszeitraums ein Wechsel zwischen den Gleichspannungspotentialen erfolgt.

Ferner ist die Überwachungsschaltung vorzugsweise an die Art des Prüfsignals anzupassen.

Im Fall eines konstanten Gleichspannungspotentials ist die Überwachungsschaltung so auszubilden, daß diese das Gleichspannungspotential selbst ständig oder in den vorgesehenen Überwachungszeiträumen erfaßt.

Insbesondere bei mehreren Gleichspannungspotentialen ist es jedoch günstig, wenn die Überwachungsschaltung Differenzen zwischen den Gleichspannungspotentialen auswertet.

Eine weitere günstige Lösung sieht vor, daß die Überwachungsschaltung einen Verlauf der Gleichspannungspotentiale auswertet.

Eine derartige Auswertung des Verlaufs der Gleichspannungspotentiale sieht beispielsweise vor, daß diese Periodendauern oder auch Zeitdauern einer High-Phase oder eine Low-Phase der Gleichspannungspotentiale auswertet.

Eine besonders günstige Lösung sieht vor, daß die Überwachungsschaltung Flanken einer Änderung der Gleichspannungspotentiale auswertet.

Eine andere günstige Lösung sieht im Rahmen des erfindungsgemäßen Konzepts vor, daß das Prüfsignal ein Wechselspannungssignal ist, wobei es besonders günstig ist, wenn das Prüfsignal ein hochfrequentes Wechselspannungssignal ist, da in diesem Fall nicht nur die Möglichkeit besteht, Spannung desselben zu erfassen, sondern auch Frequenzanteile und gegebenenfalls die Frequenzanteile ergänzend zu den Spannungen auszuwerten.

Eine besonders zweckmäßige Ausführungsform der erfindungsgemäßen Lösung sieht dabei vor, daß das Detektorleitungssystem und das mindestens eine Abstützelemente eines Schwingkreises bilden, so daß der Frequenzverlauf des Prüfsignals auswertbar ist.

Beispielsweise ist hierzu vorgesehen, daß die Überwachungsschaltung Frequenzkomponenten des Prüfsignals auswertet.

Eine derartige Auswertung von Frequenzkomponenten des Prüfsignals läßt sich besonders günstig dann durchführen, wenn die Überwachungsschaltung die Frequenzkomponenten über Bandfilter erfaßt.

Hinsichtlich der Ausbildung der Detektorschaltung selbst wurden im Zusammenhang mit der bisherigen Erläuterung der Erfindung keine näheren Angaben gemacht. So sieht ein vorteilhaftes Ausführungsbeispiel vor, daß die Detektorschaltung eine Überwachungsschaltung mit einem Lernmodus aufweist, in welchem der Sollwertbereich für das Prüfsignal ermittelbar ist.

Somit läßt sich für jedes erfindungsgemäße Versorgungsnetzwerk eine Abstimmung auf die tatsächliche Ausdehnung des Detektorleitungssystems und die Abschlußelemente vornehmen.

Dies ist nicht nur bei Gleichspannungssignal als Prüfsignal von Vorteil, sondern insbesondere auch bei hochfrequenten Prüfsignalen, da sich die kapazitiven und induktiven Einflüsse im Rahmen der Produktion schwerlich mit der erforderlichen Präzision festlegen lassen.

Ferner ist es besonders günstig, wenn die Steuerschaltung den Sollwertbereich ausgehend von einem Meßwert für das Prüfsignal bei defektfreiem Detektorleitungssystem mit dem mindestens einen Abschlußelement ermittelt.

Die Festlegung des Sollwertbereichs ist bei einer Messung des Prüfsignals nicht möglich.

Zweckmäßigerweise ist daher der Sollwertbereich durch eine der Überwachungsschaltung vorgegebene Sollwertbandbreite festlegbar.

Die Erfindung betrifft darüber hinaus ein elektrisches Versorgungsnetzwerk für Bordnetze von Fahrzeugen, umfassend mindestens ein Netzwerksystem mit einem Stromeinspeiseanschluß und mindestens einem Verbraucheranschluß und mit einem von dem Einstromeinspeiseanschluß zu mindestens einem Verbraucheranschluß geführten Versorgungsleitungssystem, welches mindestens einen stromführenden Leitungsstrang und lösbare Leistungskontaktelemente für den stromführenden Leistungsstrang aufweist.

Ausgehend von einem derartigen elektrischen Versorgungsnetzwerk wird die eingangs genannte Aufgabe erfindungsgemäß dadurch gelöst, daß ein Überwachungsleitungssystem vorgesehen ist, welches mindestens eine Überwachungsleitung und lösbare Überwachungskontaktelemente in der Überwachungsleitung aufweist, daß die Überwachungskontaktelemente derart mit den Leistungskontaktelementen gekoppelt sind, daß ein Lösen der Überwachungskontaktelemente spätestens mit einem Lösen der Leistungskontaktelemente oder vorher erfolgt und daß eine Überwachungsschaltung vorgesehen ist, welche mittels eines Prüfsignals das Überwachungsleitungssystem überwacht und mittels einer Abschalteinrichtung bei gelösten Überwachungskontaktelementen einen Stromfluß durch den stromführenden Leitungsstrang unterbricht.

Der Vorteil dieser Lösung ist darin zu sehen, daß damit kein unbeabsichtigtes Lösen der Leistungskontaktelemente bei stromführendem Leitungsstrang erfolgen kann, so daß sich das damit auch beim Lösen der Leistungskontaktelemente eine Bildung eines Lichtbogens verhindert werden kann.

Ein weiterer Vorteil dieser Lösung liegt darin, daß der stromführende Teil des Leitungsstranges spannungslos geschaltet wird und damit unzulässig hohe Berührungsspannungen vermieden werden können.

Besonders günstig ist es, wenn die Überwachungskontaktelemente derart angeordnet sind, daß die Leistungskontaktelemente nur dann lösbar sind, wenn die Überwachungskontaktelemente bereits kontaktfrei zueinander sind.

Diese Lösung hat den großen Vorteil, daß damit auf jeden Fall bereits vor einem Lösen der Leistungskontaktelemente sichergestellt ist, daß der Stromfluß durch den stromführenden Leitungsstrang unterbrochen ist.

Besonders günstig läßt sich eine derartige Ausführungsform mechanisch realisieren, wenn die Überwachungskontaktelemente in ihrer kontaktgebenden Stellung ein Lösen der Leistungskontaktelemente mechanisch blockieren.

Ein derartiges mechanisches Blockieren könnte prinzipiell dadurch erreichbar sein, daß die Leistungskontaktelemente und die Überwachungskontaktelemente nicht in einer gemeinsamen Einheit integriert sind, sondern in zwei getrennten Einheiten vorgesehen sind, allerdings die Einheit mit den Überwachungskontaktelementen so ausgeführt ist, daß dieser ein Lösen der Einheit, in welchen die Leistungskontaktelemente integriert sind, verhindert.

Dies ist beispielsweise dadurch möglich, daß die Einheiten derart gekoppelt sind, daß selbst ein Lösen der Einheit mit den Leistungskontaktelementen bereits vorab zu einem Lösen der Einheit für die Überwachungskontaktelemente führt.

Prinzipiell können die Kontaktelemente auch als Schraubkontaktelemente oder in anderer Weise lösbare Kontaktelemente ausgebildet sein.

Eine besonders günstige Ausbildungsform sieht jedoch vor, daß die Überwachungskontaktelemente als Elemente eines Steckkontakts ausgebildet sind, da diese sich leicht lösen lassen und somit in einfacher Weise sichergestellt werden kann, daß immer rechtzeitig vor einem Lösen der Leistungskontaktelemente ein Lösen der Überwachungskontaktelemente erfolgt.

Andererseits ist es aber auch zweckmäßig, wenn aufgrund der leichten Lösbarkeit auch die Leistungskontaktelemente als Elemente eines Steckkontakts ausgebildet sind.

Besonders günstig ist es jedoch, wenn sowohl eines der Leistungskontaktelemente und eines der Überwachungskontaktelemente in einem Steckverbinderelement und das andere der Leistungskontaktelemente und das andere der Überwachungskontaktelemente in dem anderen Steckverbinderelement angeordnet sind, so daß aufgrund dieser Anordnung bereits eine mechanische Verknüpfung zwischen den Positionen der Leistungskontaktelemente und der Überwachungskontaktelemente relativ zueinander erfolgen kann und allein aufgrund der Positionierung der Leistungskontaktelemente relativ zu den Überwachungskontaktelementen, insbesondere ihrer Erstreckung in Einsteckrichtung sichergestellt werden kann, daß die Überwachungskontaktelemente spätestens beim Trennen der Leistungskontaktelemente voneinander ebenfalls getrennt werden, möglichst jedoch die Überwachungskontaktelemente vor einer Trennung der Leistungskontaktelemente voneinander getrennt werden und andererseits wiederum die Überwachungskontaktelemente frühestens bei einer Verbindung der Leistungskontaktelemente miteinander elektrisch verbunden werden, möglichst jedoch die Überwachungskontaktelemente erst nach einer elektrischen Verbindung der Leistungskontaktelemente miteinander elektrisch verbunden werden.

Alternativ oder ergänzend zu den vorstehend beschriebenen Lösungen hat es sich, insbesondere wenn die Steckverbinderelemente durch eine mechanische Verriegelung relativ zueinander fixiert sind, als günstig erwiesen, wenn die Überwachungsschaltung eine mechanische Verbindung der Steckverbinderelemente überwacht und mittels einer Abschaltung bei gelöster mechanischer Verbindung einen Stromfluß durch den stromführenden Leitungsstrang unterbricht.

Der Vorteil dieser Lösung ist darin zu sehen, daß damit bereits eine Überwachung der mechanischen Position der Steckverbinderelemente relativ zueinander erfolgen kann.

Eine Möglichkeit, ist es, rein die relative Position der Steckverbinderelemente zueinander zu überwachen.

Eine andere vorteilhafte Möglichkeit sieht vor, daß die Überwachungsschaltung eine Verriegelungsvorrichtung der Steckverbinderelemente überwacht und bereits bei Lösen der Verriegelungsvorrichtung, ohne daß mit einem Lösen der Steckverbinderelemente begonnen wurde, den Stromfluß durch den stromführenden Leitungsstrang unterbricht.

Eine derartige Überwachung der mechanischen Verbindung der Steckverbinderelemente kann alternativ oder ergänzend zur Überwachung einer Überwachungsleitung oder auch des Detektorleitungssystems erfolgen.

Beispielsweise ist es auch denkbar, eine derartige Überwachung der mechanischen Verbindung der Steckverbinderelemente unabhängig von dem Detektorleitungssystem oder der Überwachungsleitung vorzusehen und der jeweiligen Komponente, an welcher der Steckverbinder angeordnet ist, zuzuordnen.

Es ist aber genauso denkbar, die Überwachung der mechanischen Steckverbindung in die Gesamtüberwachung zu integrieren.

Besonders vorteilhaft ist es im Rahmen der beschriebenen Lösung, wenn das Überwachungsleitungssystem mit dem Detektorleitungssystem identisch ist, so daß als Überwachungsschaltung auch die in der Detektorschaltung vorgesehene Überwachungsschaltung eingesetzt werden kann.

Es ist aber auch denkbar, zusätzlich zu der in der Detektorschaltung vorgesehenen Überwachungsschaltung noch weitere, unabhängig von dieser arbeitende Überwachungsschaltungen vorzusehen.

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: ein Schaltschema eines ersten Ausführungsbeispiels eines erfindungsgemäßen Versorgungsnetzwerks;
- Fig. 2: eine schematische Darstellung einer Funktion einer Überwachungsschaltung;

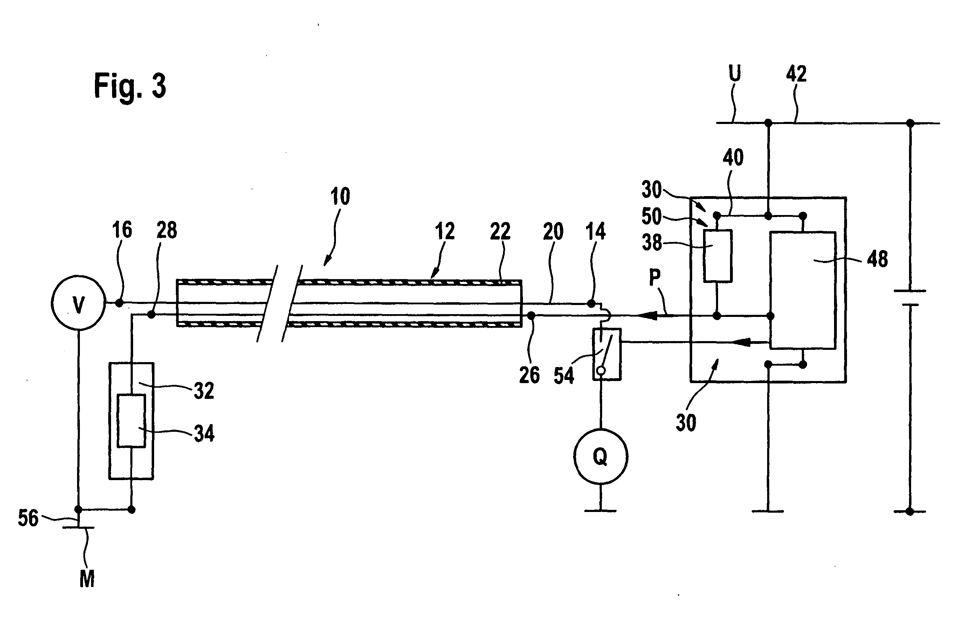

- Fig. 3: ein Schaltschema eines zweites Ausführungsbeispiels;
- Fig. 4: ein Schaltschema eines dritten Ausführungsbeispiels;
- Fig. 5: ein Schaltschema eines vierten Ausführungsbeispiels;
- Fig. 6: ein Schaltschema eines fünften Ausführungsbeispiels;
- Fig. 7: ein Schaltschema eines sechsten Ausführungsbeispiels;
- Fig. 8: ein Schaltschema eines siebten Ausführungsbeispiels;
- Fig. 9: ein Schaltschema eines achten Ausführungsbeispiels;
- Fig. 10: ein Schaltschema eines neunten Ausführungsbeispiels;
- Fig. 11: ein Schaltschema eines zehnten Ausführungsbeispiels;
- Fig. 12: eine Darstellung eines Verlaufs eines Prüfsignals bei mehreren Gleichspannungspotentialen;
- Fig. 13: eine Darstellung einer Auswertung in einem Flankenbereich bei einem Prüfsignal gemäß Fig. 12;
- Fig. 14: eine alternative Darstellung einer Auswertung eines Flankenbereichs bei einem Prüfsignal gemäß Fig. 12;
- Fig. 15: ein Schaltschema eines elften Ausführungsbeispiels;
- Fig. 16: ein Schaltschema eines zwölften Ausführungsbeispiels;
- Fig. 17: ein Schaltschema eines dreizehnten Ausführungsbeispiels;
- Fig. 18: ein Schaltschema eines vierzehnten Ausführungsbeispiels;
- Fig. 19: ein Schaltschema eines fünfzehnten Ausführungsbeispiels;
- Fig. 20: einen Längsschnitt durch einen vorzugsweise bei dem zwölften, dreizehnten und vierzehnten Ausführungsbeispiel eingesetzten Steckverbinder mit getrennten Steckverbinderelementen;
- Fig. 21: einen Schnitt ähnlich Fig. 20 beim sich beginnendem Zusammenstecken der Steckverbinderelemente und Herstellung eines elektrischen Kontaktes zwischen Leistungskontaktelementen;
- Fig. 22: einen Schnitt ähnlich Fig. 20 bei weiterem Zusammenstecken der Steckverbinderelemente bei bestehendem elektrischem Kontakt zwischen Leistungskontaktelementen und beginnendem elektrischem Kontakt zwischen Überwachungskontaktelementen;
- Fig. 23: eine Darstellung der vollständig zusammengesteckten Steckverbinderelemente und

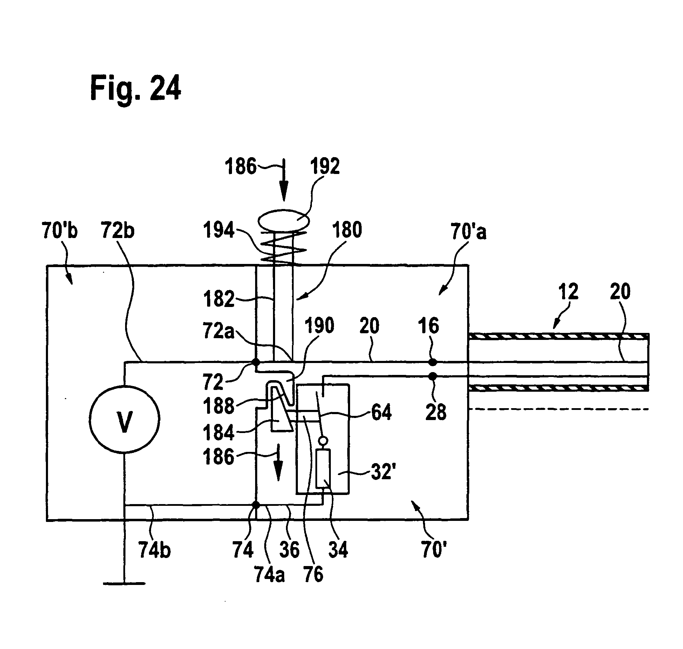

- Fig. 24: einen schematischen Schnitt durch einen weiteren beispielsweise im Zusammenhang mit dem fünften Ausführungsbeispiel gemäß Fig. 6 einsetzbaren Steckverbinder.

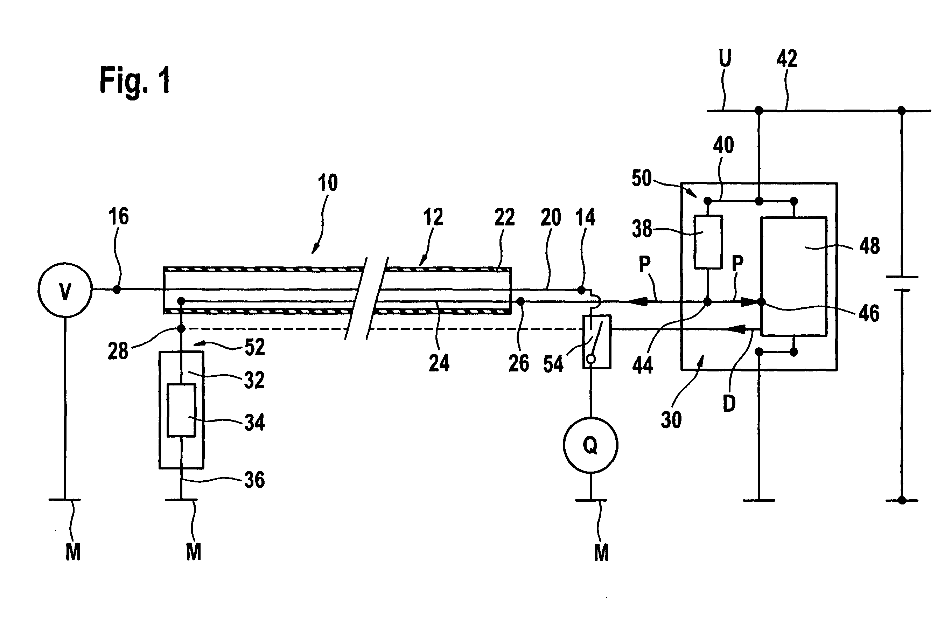

Ein erstes Ausführungsbeispiel eines elektrischen Versorgungsnetzwerks, mit einem in Fig. 1 als Ganzes mit 10 bezeichneten Netzwerksystem, insbesondere ein Stromversorgungsnetzwerk für Bordnetze von Fahrzeugen, vorzugsweise Kraftfahrzeugen, dient dazu, Strom von einer Stromquelle Q einen Verbraucher V zuzuführen.

Hierzu umfaßt das elektrische Netzwerksystem 10 ein Versorgungsleitungssystem 12, welches über einen Stromeinspeiseanschluß 14 mit der Stromquelle Q verbunden ist und über mindestens einen Verbraucheranschluß 16 mit dem Verbraucher V verbunden ist.

Bei Bordnetzen von Fahrzeugen, insbesondere Kraftfahrzeugen, liegen sowohl die Stromquelle Q und auch der Verbraucher V einerseits auf Masse M, so daß das Versorgungsleitungssystem 12 lediglich einen stromführenden Leitungsstrang 20 benötigt, welcher vom Stromspeiseanschluß 14 zum Verbraucheranschluß 16 geführt ist.

Der Leitungsstrang 20 ist dabei zur elektrischen Isolierung desselben von einem Schutzmantel 22 umgeben, welcher diesen gegenüber der Umgebung, und bei Fahrzeugen, insbesondere Kraftfahrzeugen, auch gegen die Karosserie und folglich gegen Masse isoliert.

Insbesondere in all den Fällen, in denen der Leitungsstrang 20 mit Spannungen betrieben wird, die über 12 Volt, vorzugsweise oberhalb 20 Volt liegen, besteht ein latentes Gefahrenpotential bei Defekten des Leitungsstrangs 20 selbst oder defekten im Schutzmantel 22, daß sich in einem derartigen Fall ein Lichtbogen bilden kann, welcher seinerseits eine erhebliche Brandgefahr darstellt.

Aus diesem Grund ist dem Versorgungsleitungssystem 12 ein Detektorleitungssystem 24 zugeordnet, welches beispielsweise eine in dem Versorgungsleitungssystem 12 im wesentlichen längs des Leitungsstrangs 20 verlaufende Detektorleitung 25 aufweist, die beispielsweise auch um diesen herum in der unterschiedlichsten Art verlaufen kann.

Das Detektorleitungssystem 24 und die Detektorleitung 25 können dabei beispielsweise so ausgebildet werden, wie dies in der DE 102 34 389.6-34 oder der EP 03 016 367.9 umfassend beschrieben ist. Aus diesem Grund wird diesbezüglich vollinhaltlich auf die Ausführungen in diesen Anmeldungen Bezug genommen.

Das dem Versorgungsleitungssystem 12 zugeordnete Detektorleitungssystem 24 weist dabei ein erstes Endes 26, sowie ein zweites Ende 28 auf, die jeweils nahe den Anschlüssen 14, 16 des Versorgungsleitungssystems 12 liegen und insbesondere diesen Anschlüssen 14, 16 zugeordnet sind.

Erfindungsgemäß ist das erste Ende 26 mit einer als Ganzes mit 30 bezeichneten Detektorschaltung verbunden. Das weitere Ende 28 ist seinerseits mit einem als Ganzes mit 32 bezeichneten Abschlußelement verbunden, das seinerseits im einfachsten Fall in einer Verbindungsleitung 36 zwischen dem weiteren Ende 28 des Detektorleitungssystems 24 und der Masse M liegt.

Vorzugsweise ist insgesamt der elektrische Widerstand des Abschlußelements 32 so gewählt, daß dieser mindestens um einen Faktor 10, noch besser um einen Faktor 50 und besonders zweckmäßig um einen Faktor 100, größer ist als der elektrische Widerstand des Detektorleitungssystems 24 zwischen dem ersten Ende 26 und dem weiteren Ende 28.

Die Detektorschaltung 30 umfaßt ihrerseits ebenfalls einen elektrischen Widerstand 38, welcher in einer Verbindungsleitung 40 zwischen einer Spannungsversorgung 42 und einem Mittelabgriff 44 angeordnet ist.

Der Mittelabgriff 44 ist seinerseits unmittelbar mit dem ersten Ende 26 des Detektorleitungssystems 24 verbunden und außerdem noch verbunden mit einem Eingang 46 einer Überwachungsschaltung 48.

Die Verbindungsleitung 40 und der elektrische Widerstand 38 bilden somit einen ersten Zweig 50 eines zwischen der Spannungsversorgung 42 und Masse liegenden Spannungsteiler, während das Detektorleitungssystem 24 mit der Verbindungsleitung 36 und dem in dieser angeordneten Abschlußelement 32 einen zweiten Zweig 52 dieses Spannungsteilers bilden, wobei beide Zweige 50, 52 ein an dem Mittelabgriff 44 entstehendes Prüfsignal P beeinflussen.

Im einfachsten Fall sind die elektrischen Widerstände 34 und 38 Ohm'sche Widerstände, so daß bei Anlegen einer Gleichspannung U an der Spannungsversorgung 42 das Prüfsignal P dem sich am Mittelabgriff einstellenden elektrischen Potential zwischen der Gleichspannung U und Masse M entspricht.

Dieses Gleichspannungspotential liegt auch am Eingang 46 der Überwachungsschaltung 48 an und kann somit von dieser detektiert werden.

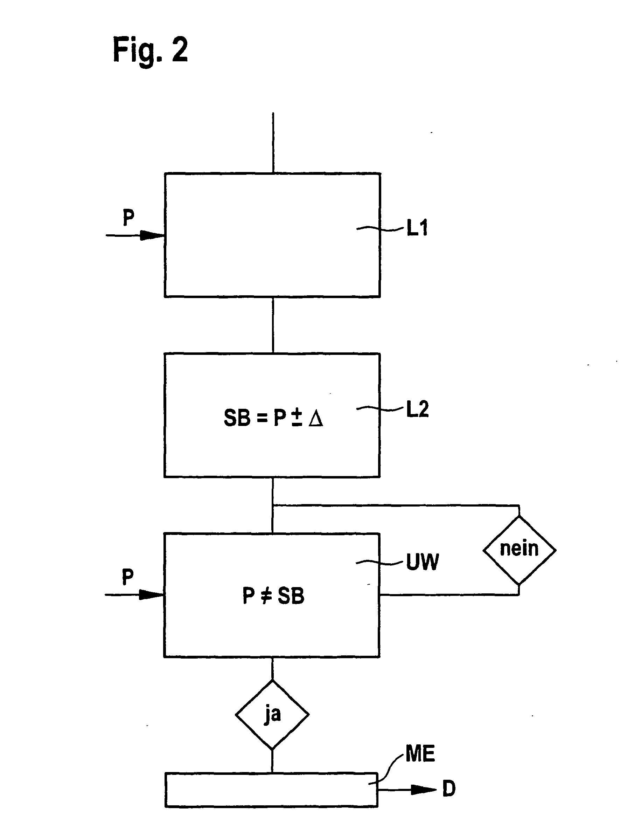

Um nun eine zuverlässige Überwachung des Versorgungsleitungssystems 12 zu erhalten, ist die Überwachungsschaltung 48 so konzipiert, daß diese zunächst in einem in Fig. 2 dargestellten Lernmodus betrieben wird.

In dem Lernmodus wird in einem ersten Schritt L1 das Prüfsignal P, im einfachsten Fall das sich am Mittelabgriff 44 einstellende Potential, eingelesen.

In einem zweiten Schritt L2 des Lernmodus wird ein Sollwertbereich SB errechnet, der sich aus dem Potential P und einer zusätzlich zum Potential P zugelassenen Schwankungsbreite Δ errechnen läßt.

Ist in dem Schritt L2 des Lernmodus der Sollwertbereich SB festgelegt, so geht die Überwachungsschaltung 48 in einen in Fig. 2 dargestellten Überwachungsmodus UW über, in welchem stets das Prüfsignal überwacht wird, nämlich dahingehend, ob dieses innerhalb des Sollwertbereichs SB oder außerhalb desselben liegt.

Liegt das Prüfsignal P innerhalb des Sollwertbereichs SB, so bleibt die Überwachungsschaltung 48 im Überwachungsmodus UW und setzt die Überwachung des Prüfsignals P fort.

Liegt das Prüfsignal P außerhalb des Sollwertbereichs SB, so springt die Überwachungsschaltung 48 in den Meldemodus ME, in welchem über ein Defektsignal D ein Defekt in dem Detektorleitungssystem 24 gemeldet wird.

Bei dieser Vorgehensweise sind unterschiedlichste Defekte des Detektorleitungssystems 24 erfaßbar.

Ein erster möglicher Defekt, wäre die Unterbrechung des Versorgungsleitungssystems 12 an beliebiger Stelle zwischen dem Stromeinspeiseanschluß 14 und dem Verbraucheranschluß 16.

Eine derartige Unterbrechung hat aufgrund der Zuordnung des Detektorleitungssystems 24 zum Versorgungsleitungssystem 12 zwangsläufig auch die Unterbrechung des Detektorleitungssystems 24 zur Folge.

Eine derartige Unterbrechung führt dazu, daß sich das Potential am Mittelabgriff 44 dem Potential der Spannungsversorgung 42 angleicht und somit das Prüfsignal P selbst ein Potential hat, das außerhalb des Sollwertbereichs SB liegt, wenn man diesen so definiert, daß dieser beispielsweise eine Abweichung vom gemessenen Prüfsignal P um +/- 10% zuläßt.

Ein weiterer Defekt wäre ein Kurzschluß zwischen dem Detektorleitungssystem 24 und Masse M. Dieser kommt beispielsweise dadurch zustande, daß das Versorgungsleitungssystem 12 durch Reibung oder andere mechanische Einflüsse mechanisch soweit geschädigt wird, daß eine Verbindung zwischen dem Detektorleitungssystem 24 und einem Masse führenden Teil, beispielsweise einem Karosserieteil, entstehen kann. Aufgrund dieses Kurzschlusses entfällt der Einfluß des Abschlußelements 32, so daß das Prüfsignal P ebenfalls Werte annimmt, die außerhalb des Sollwertbereichs SB liegen.

Ein derartiger Kurzschluß kann nicht nur gegenüber der Masse M auftreten, sondern beispielsweise auch gegenüber einem auf dem Potential der Spannungsversorgung 42 liegenden Teil. Auch in diesem Fall verändert sich das Prüfsignal derart gravierend, daß dieses außerhalb des Sollwertbereichs SB liegt.

Ein weiterer Defekt wäre die Ausbildung eines Lichtbogens, entweder aufgrund zweier einander gegenüberliegender Teile des Leitungsstrangs 20 aufgrund einer Unterbrechung lediglich des Leitungsstrangs 20 oder durch Beschädigung des Schutzmantels 22 derart, daß sich ein Lichtbogen zwischen dem Leitungsstrang 20 und beispielsweise Masse oder einem anderen Potential ausbildet.

Ist dabei das Detektorleitungssystem 24 so konzipiert, daß dieses sein elektrisches Verhalten beim Auftreten eines lokalen Lichtbogens irreversibel verändert, insbesondere im Laufe der Zeit zu einer Unterbrechung der elektrischen Leitfähigkeit herbeiführt, so führt ein derartiger Lichtbogen dazu, daß sich auch der elektrische Widerstand des Detektorleitungssystems 24 derart gravierend ändert, daß das Prüfsignal P außerhalb des Sollwertbereichs SB liegt.

Somit läßt sich durch die erfindungsgemäße Lösung eine große Zahl von Defekten über deren Einfluß auf das Prüfsignal P erkennen.

Die erfindungsgemäße Lösung ist jedoch nicht auf die Überwachung von Gleichspannungspotentialen als Prüfsignale P beschränkt.

Beispielsweise ist es denkbar, an der Spannungsversorgung 42 keine Gleichspannung sondern ein Hochfrequenzsignal anzulegen, so daß dieses ebenfalls über die beiden Zweige 50 und 52 des Spannungsteilers zur Einstellung eines hochfrequenten Prüfsignals P am Mittelabgriff 44 des Spannungsteilers führt.

Dabei können die elektrischen Widerstände 34 und 38 auch induktive oder kapazitive Widerstände sein oder auch Ohm'sche induktive und/oder kapazitive Anteile mitumfassen.

In diesem Fall erfaßt die Überwachungsschaltung 48 kein Gleichspannungspotential, sondern zumindest die Amplitude, gegebenenfalls auch die Frequenz des Prüfsignals P. Die Amplitude wird dabei durch dieselben Defekte beeinflußt, wie dies im Zusammenhang mit Gleichspannungspotentialen erläutert wurde.

Darüber hinaus besteht noch die Möglichkeit, insbesondere die Ausbildung von Lichtbogen über Einkopplungen hochfrequenter, jedoch nicht der Frequenz auf der Spannungsversorgungsleitung 42 entsprechender Frequenzanteile zu erfassen, die durch die Entstehung der Lichtbögen in das Detektorleitungssystem 24 eingekoppelt werden.

Wird von der Überwachungsschaltung 48 ein derartiger Defekt erkannt und das Defektsignal D ausgegeben, so kann dies im einfachsten Fall unmittelbar in einer Trennschaltung 54 dazu eingesetzt werden, die Verbindung zwischen dem Stromeinspeiseanschluß 14 und der Stromquelle Q zu trennen und somit jegliche, durch die Bestromung des Versorgungsleitungssystems 12 auftretende Gefahr zu vermeiden.

Bei einem zweiten Ausführungsbeispiel eines erfindungsgemäßen elektrischen Versorgungsnetzwerks mit einem Netzwerksystem 10 sind diejenigen Elemente, die mit denen des ersten Ausführungsbeispiels identisch sind, mit denselben Bezugszeichen versehen, so daß hinsichtlich der Beschreibung derselben vollinhaltlich auf die Ausführungen zum ersten Ausführungsbeispiel Bezug genommen werden kann.

Im Gegensatz zum ersten Ausführungsbeispiel ist allerdings beim zweiten Ausführungsbeispiel das Abschlußelement 32 nicht unmittelbar mit der Masse M verbunden, sondern mit einer zur Masse führenden Masseleitung 56 des Verbrauchers V, so daß bei Verlust der Masseverbindung des Verbrauchers V, beispielsweise einer Unterbrechung zwischen der Masseleitung 56 und der Masse M, dies, neben allen übrigen, bereits beschriebenen Defekten, ebenfalls als Defekt von der Überwachungsschaltung 48 erkennbar ist und ebenfalls zu einem Auslösen der Trennschaltung 54 führt.

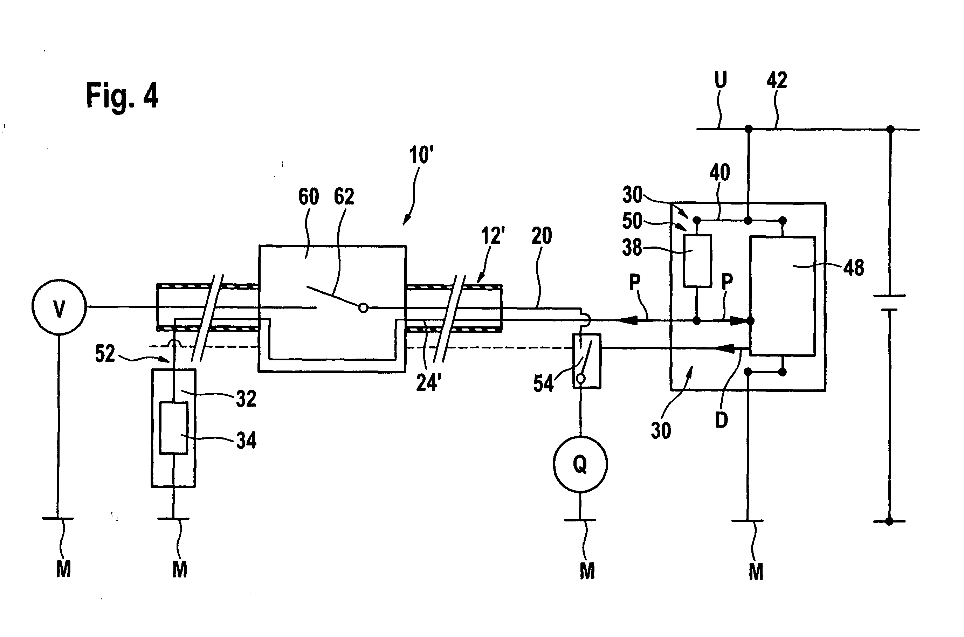

Bei einem dritten Ausführungsbeispiel, dargestellt in Fig. 4, eines erfindungsgemäßen elektrischen Versorgungsnetzwerks mit einem Netzwerksystem 10' ist in dem Versorgungsleitungssystems 12' noch ein als Ganzes mit 60 bezeichnetes Steuergerät integriert, welches seinerseits noch beispielsweise einen Schalter 62 zur Unterbrechung des Leitungsstrangs 20 umfaßt.

Bei diesem Ausführungsbeispiel ist das Detektorleitungssystem 24' durch das Steuergerät 60 hindurchgeschleift, so daß in gleicher Weise wie beim ersten Ausführungsbeispiel eine Gesamtüberwachung des Versorgungsleitungssystems 12' mitsamt dem Steuergerät 60 möglich ist, da damit aufgrund des durch das Steuergerät 60 durchgeschleiften Detektorleitungssystems 24 auch nicht nur die Möglichkeit besteht, die im Zusammenhang mit dem ersten Ausführungsbeispiel beschriebenen Defekte zu überwachen, sondern auch Defekte hinsichtlich der Verbindung zwischen dem Versorgungsleitungssystem 12 und dem Steuergerät 60, da derartige Defekte ebenfalls zu Unterbrechungen im Bereich des durch das Steuergerät 60 durchgeschleiften Detektorleitungssystems 24 führen.

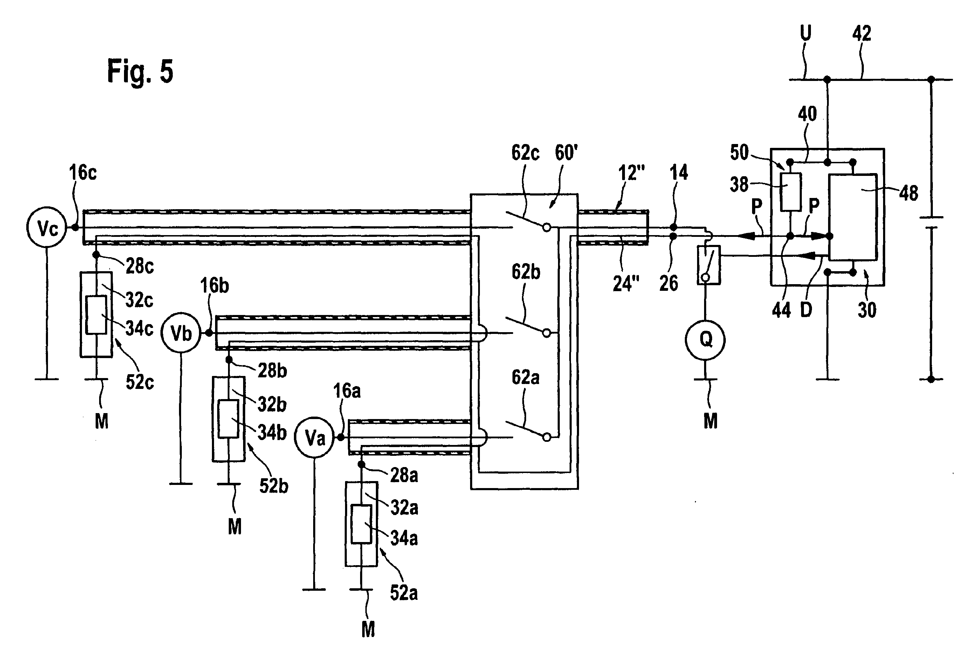

Ein viertes Ausführungsbeispiel, dargestellt in Fig. 5, sieht nicht nur ein Steuergerät 60 mit einem Schalter vor, sondern ein Steuergerät 60 mit insgesamt drei Schaltern 62a, 62b, 62c, mit denen die Möglichkeit besteht, insgesamt drei Verbraucher Va, Vb, Vc ein- oder auszuschalten.

Dabei ist das Versorgungsleitungssystem 12" so aufgebaut, daß dieses ausgehend von dem Stromeinspeiseanschluß 14 beim Durchschleifen durch das Steuergerät 60' eine Verzweigung erfährt und somit zu insgesamt drei Verbraucheranschlüssen 16a, 16b und 16c führt.

In gleicher Weise wie das Versorgungsleitungssystem 12" erfährt auch das Detektorleitungssystem 24" eine Verzweigung derart, daß dieses nunmehr nicht nur ein weiteres Ende 28 aufweist, sondern insgesamt drei weitere Enden 28a, 28b, 28c, von denen jedes über ein eigenes Abschlußelement 32a, 32b und 32c mit der Masse M verbunden ist.

In diesem Fall ist der Spannungsteiler zur Erzeugung des Prüfsignals P einerseits gebildet durch den ersten Zweig 50 und andererseits durch insgesamt drei zweite Zweige 52a, 52b und 52c, die alle zwischen dem Mittelabgriff 44 und der Masse M parallel geschaltet sind.

Tritt nun bei diesem vierten Ausführungsbeispiel beispielsweise ein Defekt in dem Versorgungsleitungssystem 12" im Bereich zwischen dem Steuergerät 60' und einem der Verbraucheranschlüsse 16a, 16b, 16c auf, so führt dies ebenfalls zu einer Veränderung des Prüfsignals P, allerdings in geringerem Maße als bei den voranstehend beschriebenen Ausführungsbeispielen, da insgesamt drei weitere Zweige 52a, 52b und 52c parallel geschaltet sind und somit nur einer der weiteren Zweige 52a, 52b, 52c des Spannungsteilers ausfällt.

In diesem Fall ist der Sollwertbereich SB entsprechend enger zu fassen und andererseits sind gegebenenfalls die elektrischen Widerstände 34a, 34b, 34c zu erhöhen.

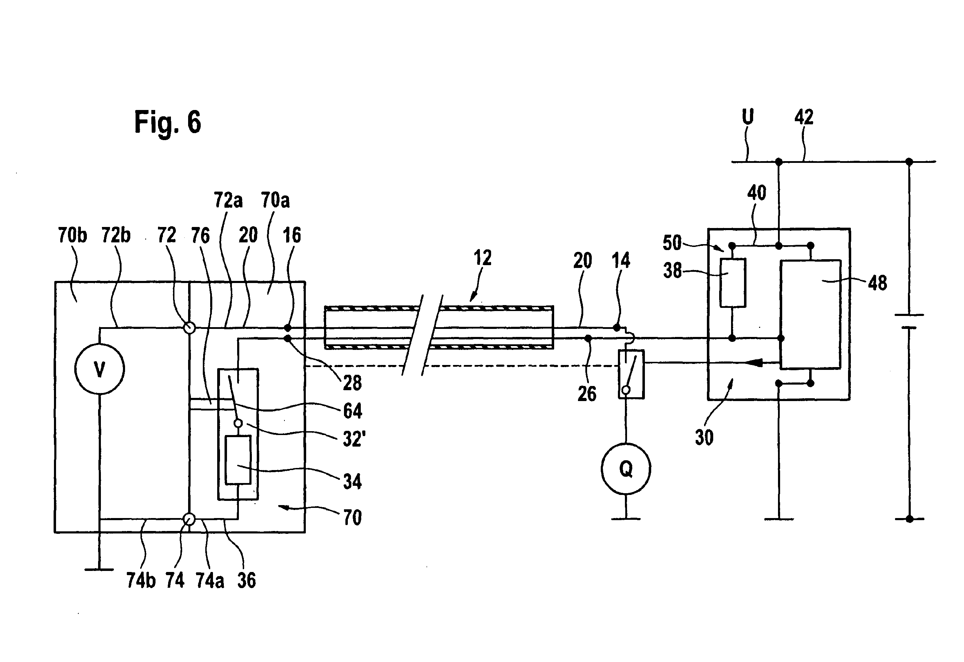

Ein fünftes Ausführungsbeispiel eines erfindungsgemäßen elektrischen Versorgungsnetzwerks, dargestellt in Fig. 6 basiert auf dem zweiten Ausführungsbeispiel, wobei das Abschlußelement 32' zusätzlich zu dem elektrischen Widerstand 34 noch einen Schalter 64 umfaßt, welcher die Möglichkeit eröffnet, weitere Defektzustände zu erkennen. Außerdem erfolgt eine Verbindung des Leitungsstrangs 20 mit dem Verbraucher V über einen Steckverbinder 70, umfassend ein versorungsleitungssystemseitiges Steckverbinderelement 70a und ein verbraucherseitiges Steckverbinderelement 70b. Der Steckverbinder weist einen lösbaren Kontakt 72 mit Kontaktelementen 72a und 72b für den Leitungsstrang 20 und einen lösbaren Kontakt 74 mit Kontaktelementen 74a und 74b für die Verbindungsleitung 36 auf.

Ist beispielsweise das Abschlußelement 32' in dem lösbaren versorgungsleitungssystemseitigen Steckverbinderelement 70a integriert, so besteht die Möglichkeit, den Schalter 64 über einen mechanischen Stößel 76 zu betätigen, der beispielsweise eine Abtastung für den sicheren Sitz der Steckverbinderelemente 70a, 70b ermöglicht, so daß der Stößel 76 den Schalter 64 dann schließt, wenn das lösbare Steckverbinderelement 70a vorschriftsmäßig eingesetzt ist. Erfolgt jedoch keine ordnungsgemäße Verbindung durch das lösbare Steckverbinderelement 70a, so schließt der Stößel 76 den Schalter 64 nicht und der zweite Zweig 52 des Spannungsteilers ist unterbrochen, so daß das Prüfsignal P nicht mehr im Sollwertbereich SB liegt.

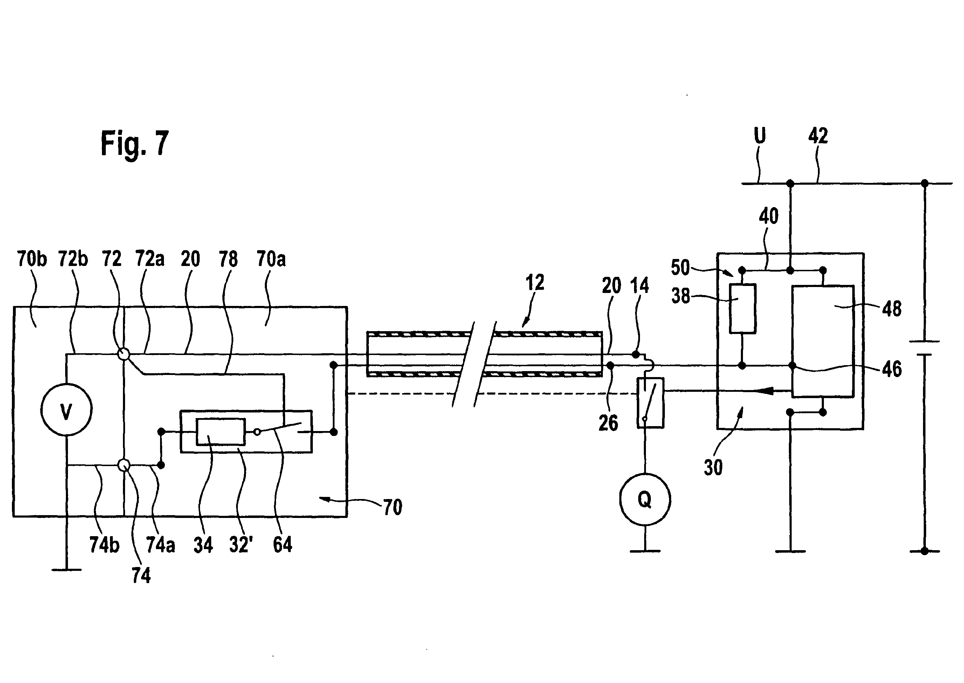

Auch bei einem sechsten Ausführungsbeispiel, dargestellt in Fig. 7 ist das lösbare versorgungsleitungssystemseitige Steckverbinderelement 70a vorgesehen, in welchem ein Abschlußelement 32' mit einem Schalter 64 integriert ist. Der Schalter 64 ist in diesem Fall jedoch nicht mechanisch durch den Stößel 76 betätigbar, sondern elektrisch betätigbar, beispielsweise über eine Steuerleitung 78, welche zu dem Leitungsstrang 20 geführt ist, und somit überprüft, ob am lösbaren Steckkontakt 72 überhaupt die von der Stromquelle Q erzeugte Spannung anliegt oder nicht. Somit läßt sich bei diesem Ausführungsbeispiel unmittelbar überprüfen, ob der Leitungsstrang 20 in vollem Umfang elektrisch leitend ist und jede Unterbrechung im Leitungsstrang 20, sogar ohne Beschädigung des Schutzmantels 22 würde zu einem Öffnen des Schalters 64 und somit zur Erzeugung des Defektsignals D seitens der Überwachungsschaltung 48 führen.

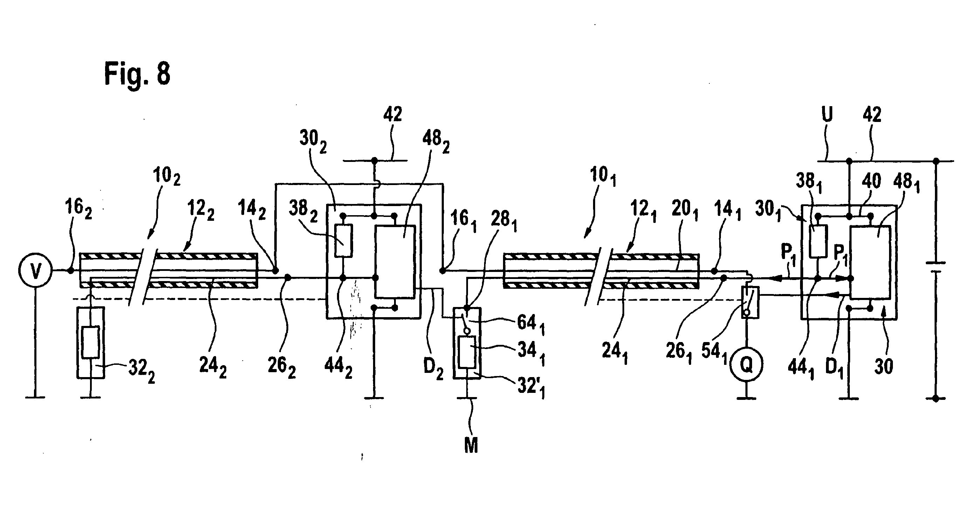

Ein siebtes Ausführungsbeispiel eines erfindungsgemäßen elektrischen Versorgungsnetzwerks, dargestellt in Fig. 8, umfaßt zwei hintereinander angeordnete Netzwerksysteme 10₁ und 10₂, wobei das erste Netzwerksystem 10₁ ein Abschlußelement 32'₁ mit einem Schalter 64₁ umfaßt.

Die Überwachungsfunktionen des ersten Netzwerksystems entsprechen beispielsweise den im Zusammenhang mit dem sechsten oder siebten Ausführungsbeispiel beschriebenen Überwachungsfunktionen.

Allerdings ist bei dem ersten Netzwerksystem 10₁ an dessen Verbraucheranschluß 16₁ nicht unmittelbar der Verbraucher V angeschlossen, sondern ein zweites Netzwerksystem 10₂ mit seinem Stromeinspeiseanschluß 14 zwischengeschaltet, so daß an dessen Verbraucheranschluß 16₂ der Verbraucher V angeschlossen ist.

Das zweite Netzwerksystem 10₂ umfaßt seinerseits eine eigene Detektorschaltung 30₂ mittels deren Defektsignal D₂ der Schalter 64₁ ansteuerbar ist.

Das heißt, daß die Detektorschaltung 30₂ das Netzwerksystem 10₂ hinsichtlich möglicher Defekte in gleicher Weise, wie bereits im Zusammenhang mit den vorstehenden Ausführungsbeispielen beschrieben, überwacht, jedoch deren Defektsignal D₂ dadurch auf das erste Netzwerksystem 10₁ rückwirkt, daß eine Betätigung des Schalters 64₁ im Abschlußelement 32'₁ erfolgt und somit im ersten Netzwerksystem 10₁ das Defektsignal D₁ auslöst, das seinerseits wiederum die Trennschaltung 54₁ ansteuert und somit die Stromquelle Q von dem Stromeinspeiseanschluß 14₁ des ersten Netzwerksystems trennt.

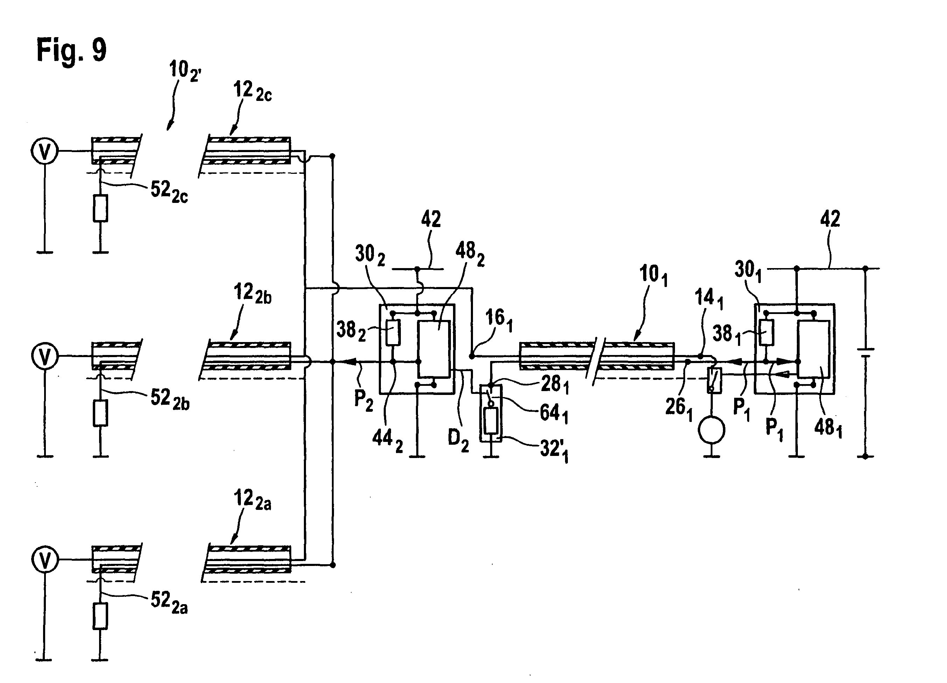

Ein achtes Ausführungsbeispiel eines erfindungsgemäßen elektrischen Versorgungsnetzwerks, dargestellt in Fig. 9 basiert auf dem siebten, in Fig. 8 dargestellten Ausführungsbeispiel, mit dem Unterschied, daß das zweite Netzwerksystem 10_{2'} drei parallelgeschaltete Versorgungsleitungssysteme 12₂ₐ, 12_{2b} und 12_{2c} aufweist, die alle parallel von dem Verbraucheranschluß 16₁ des ersten Netzwerksystems 10₁ gespeist werden, und gleichzeitig auch parallel durch eine Detektorschaltung 30₂ überwacht werden, so daß an dem Mittelabgriff 44₂ insgesamt drei zweite Zweige 52₂ₐ, 52_{2b}, und 52_{2c} parallel geschaltet angeschlossen sind und alle drei zweiten Zweige 52₂ₐ, 52_{2b}, und 52_{2c} gleichzeitig das Prüfsignal P₂ beeinflussen.

Damit arbeitet die Überwachung des zweiten Netzwerksystems 10_{2'} ähnlich der des vierten, in Fig. 5 dargestellten Ausführungsbeispiels eines erfindungsgemäßen Versorgungsnetzwerks.

Ferner wirkt das Defektsignal D₂, welches von der Detektorschaltung 30₂ des zweiten Netzwerksystems 10_{2'} erzeugt wird, auf den Schalter 64₁ des Abschlußelements 32'₁ des ersten Netzwerksystems 10₁, so daß im ersten Netzwerksystem 10₁ durch die Detektorschaltung 30₁ sämtliche Defektzustände desselben sowie Defektzustände des zweiten Netzwerksystems 10_{2'}erfassbar sind.

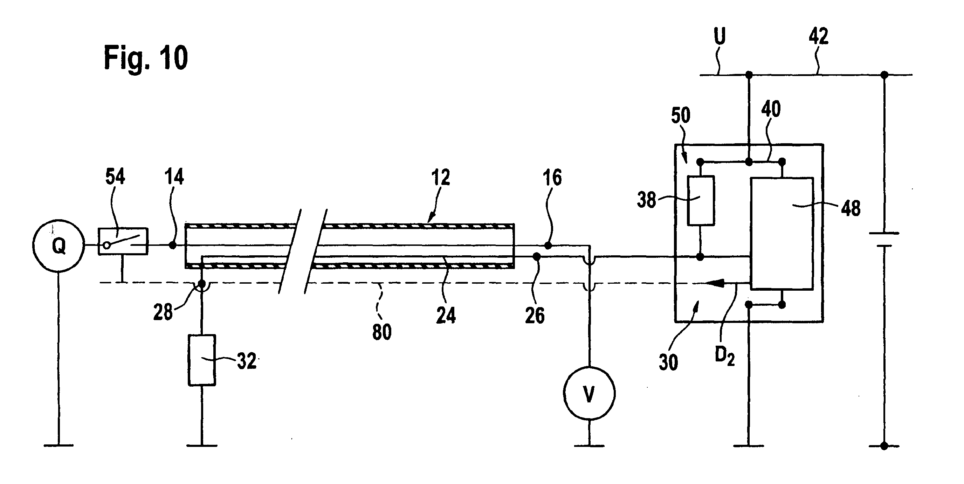

Ein neuntes Ausführungsbeispiel eines erfindungsgemäßen elektrischen Versorgungsnetzwerks, dargestellt in Fig. 10 basiert vom Prinzip her auf dem ersten Ausführungsbeispiel, mit dem Unterschied, daß der Stromeinspeiseanschluß 14 des Versorgungsleitungssystems 12 und das weitere Ende 28 des Detektorleitungssystems 24 am selben Ende des Versorgungsleitungssystems 12 einander zugeordnet sind, während ebenfalls der Verbraucheranschluß 16 und das erste Ende 26 des Detektorleitungssystems 24 ebenfalls am selben Ende des Versorgungsleitungssystems 12 einander zugeordnet sind.

Das heißt, daß die Detektorschaltung 30 an dem Ende des Versorgungsleitungssystems 12 angeordnet ist, welches dem Stromeinspeiseanschluß 14 abgewandt ist. Eine zwischen der Stromquelle Q und dem Stromeinspeiseanschluß 14 angeordnete Trennschaltung 54 ist daher entweder über eine zusätzlich längs des Versorgungsleitungssystems 12 geführte Steuerleitung 80 oder über ein Bussystem anzusteuern.

Im übrigen funktioniert das neunte Ausführungsbeispiel in gleicher Weise, wie im Zusammenhang mit dem ersten Ausführungsbeispiel beschrieben.

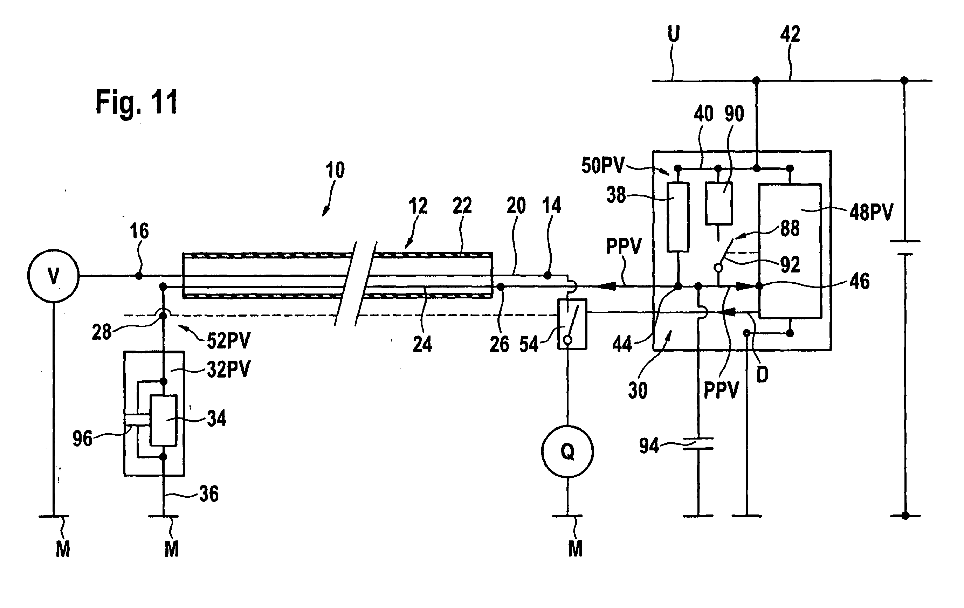

Bei einem zehnten Ausführungsbeispiel eines erfindungsgemäßen Versorgungsnetzwerks, dargestellt in Fig. 11, ist dem elektrischen Widerstand 38 ein Parallelpfad 88 parallelgeschaltet, welcher einen Widerstand 90 und einen Schalter 92 aufweist.

Der Schalter 92 ist dabei vorzugsweise durch die Überwachungsschaltung 48V ansteuerbar.

Somit wird der erste Zweig 50PV des Spannungsteilers nicht nur durch die Verbindungsleitung 40 und den Widerstand 38 gebildet, sondern den bei geschlossenem Schalter 92 parallelgeschalteten elektrischen Widerstand 90 und bei geöffnetem Schalter lediglich durch die Verbindungsleitung 40 und den Widerstand 38.

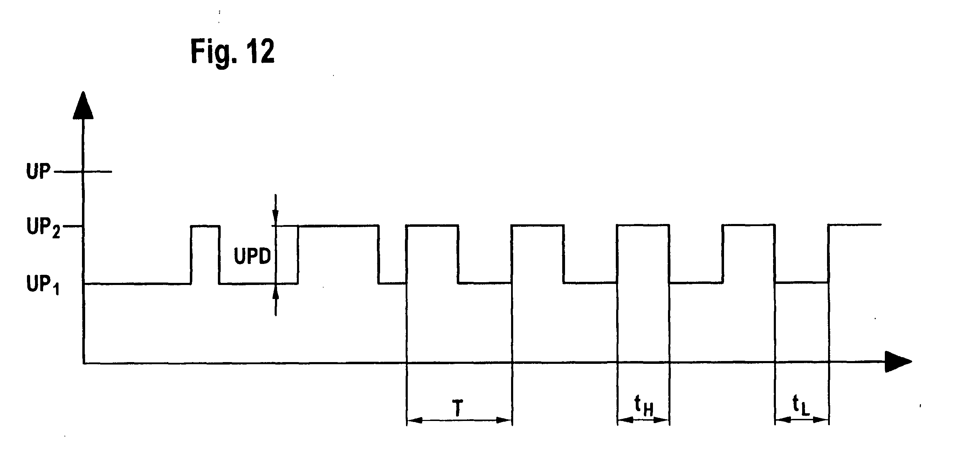

Damit besteht die Möglichkeit, je nachdem, ob der Schalter 92 geschlossen oder geöffnet ist, das das Prüfsignal PPV bildende Potential UP, wie in Fig. 12 dargestellt, zwischen dem Wert UP₁, der bei geöffnetem Schalter 92 und somit lediglich wirksamem elektrischem Widerstand 38 sich einstellt, und dem Wert UP₂, der sich bei geschlossenem Schalter 92 und somit bei dem elektrischen Widerstand 38 parallel geschaltetem elektrischem Widerstand 90 einstellt, zu variieren, wie in Fig. 12 dargestellt.

Die Überwachungsschaltung 48PV muß dabei das Potential zwischen UP₁ und UP₂ nicht gemäß einer periodischen Funktion ändern, sondern kann auch beliebig stochastische Variationen durchführen oder auch das Prüfsignal bei einem der Potentiale UP₁ oder UP₂ belassen und nur dann, wenn ein Überwachungszyklus durchgeführt werden soll, kurz zwischen UP₁ und UP₂ oder umgekehrt durch Betätigung des Schalters 92 hin- und herwechseln.

Die Überwachungsschaltung 48 kann bei diesem Ausführungsbeispiel das Prüfsignal PPV bei einem der Potentiale UP₁ und UP₂ zur Messung heranziehen, oder sie kann im einfachsten Fall die Differenz zwischen den Potentialen UP₁ und UP₂ ermitteln.

Da bei der Ermittlung der Differenz zwischen den Potentialen UP₁ und UP₂ der zweite Zweig 52 des Spannungsteilers derselbe ist und auch Variationen im Massepotential, die bei einem Fahrzeug, dessen Karosserie auf Masse M liegt, leicht auftreten können, in gleicher Weise auf den zweiten Zweig 52 sowohl bei der Messung des Potentials UP₁ oder der Messung des Potentials UP₂ auswirken, ist eine derartige Differenzermittlung zwischen den Potentialen UP₁ und UP₂ unabhängig von einem sogenannten "Masseversatz" in einer Fahrzeugkarosserie.

Die Auswertung erfolgt in diesem Fall analog zum ersten Ausführungsbeispiel unter Heranziehung des Differenzsignals UPD, welches dann anstelle des Prüfsignals PPV mit dem Sollwertbereich SB verglichen wird.

Der Sollwertbereich SB kann dabei, ebenfalls wie beim ersten Ausführungsbeispiel beschrieben, in den Schritten L1 und L2 des Lernmodus bestimmt werden, wobei ebenfalls anstelle des unmittelbaren Prüfsignals PPV der Wert UPD zur Ermittlung des Sollwertbereichs SB herangezogen wird.

Alternativ oder ergänzend zur Ermittlung der Differenz UPD besteht bei dem zehnten Ausführungsbeispiel auch noch die Möglichkeit, die Periodendauer T aufeinanderfolgender Pulse auszuwerten, wenn der Schalter 92 zyklisch mit einer bestimmten Frequenz geschaltet wird.

Es ist aber auch möglich, bei einem fest vorgegebenen Periodenverlauf die Zeiten der High-Phase t_{H} oder die Zeiten der Low-Phase t_{L} durch die Überwachungsschaltung auszuwerten.

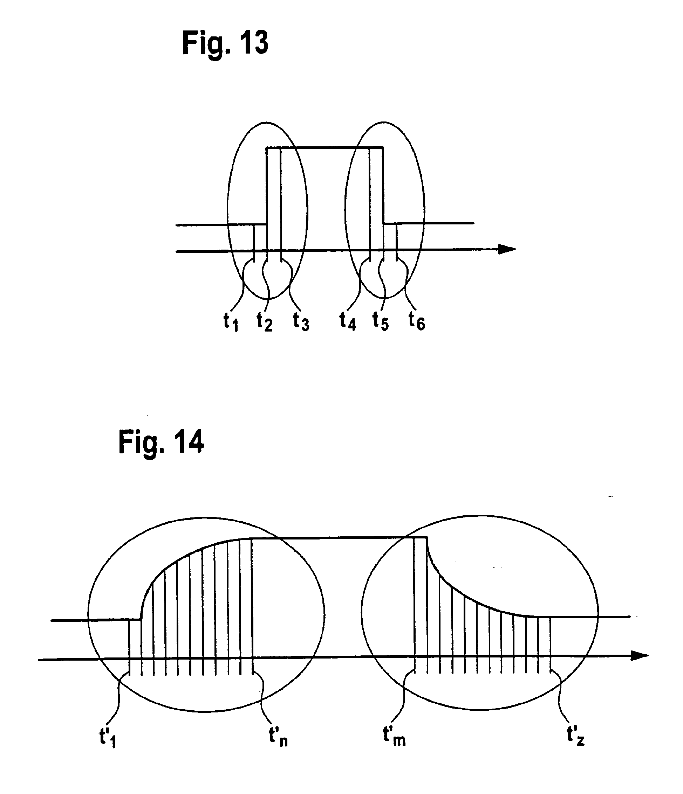

Schließlich besteht, wie in Fig. 13 dargestellt, auch noch die Möglichkeit, die Anstiegsflanke und die Abstiegsflanke durch Abtastung des gesamten Verlaufs des Potentials UP des Prüfsignals PPV auszuwerten, beispielsweise in Zeiträumen zwischen den Zeitpunkten t₁ bis t₆, wie in Fig. 13 dargestellt, insbesondere zu den Zeitpunkten t₁ und t₃ sowie t₄ und t₆.

Wenn bei dem zehnten Ausführungsbeispiel, wie in Fig. 11 dargestellt, noch zwischen dem Mittelabgriff 44 des durch die Zweige 50 und 52 gebildeten Spannungsteilers und Masse M ein Kondensator 94 vorgesehen ist, und außerdem auch das Abschlußelement 32PV noch einen dem Widerstand 34 parallel geschalteten Kondensator 96 umfaßt, so wird die Anstiegsflanke und Abstiegsflanke des gesamten Verlaufs des Potentials UP des Prüfsignals PPV, wie in Fig. 14 dargestellt, zeitlich verzögernde Anstiegs- und Abfallflanken aufweisen, die sich ebenfalls durch Abtasten während der Zeitpunkte t'₁ bis t'ₙ und t'ₙ und t'ₘ bis t'_{z} ermitteln lassen.

Ein derartiges Abtasten, wie in Fig. 13 und 14 beschrieben, erfolgt im einfachsten Fall derart, daß die Überwachungsschaltung 48PV durch einen AD-Wandler zu den einzelnen Zeitpunkten t das Potential UP des Prüfsignals PPV erfaßt und abspeichert und dann beim nächsten Zeitpunkt t wieder erfaßt und abspeichert.

Das zehnte Ausführungsbeispiel arbeitet im störungsfreien Zustand des Detektorleitungssystems 24 so, daß in bestimmten Zeiträumen das Potential UP des Prüfsignals P zwischen den Werten UP₁ und UP₂ durch Betätigung des Schalters 92 seitens der Überwachungsschaltung 48 hin und her geschaltet wird.

Funktioniert das System einwandfrei, so ist bei Bestimmung der Differenz UPD zwischen den Potentialen UP₁ und UP₂ des Prüfsignals P diese Differenz UPD im Sollwertbereich SB.

Ist beispielsweise das Detektorleitungssystem 24 derart unterbrochen, daß keine Verbindung mehr zu einem der Abschlußelemente 32PV, insbesondere zu dem Abschlußelement 32PV, besteht, so liegt kein Prüfsignal mehr vor und die Differenz UPD existiert ebenfalls nicht mehr.

Erfolgt ein Schluß des Detektorleitungssystems 24 mit einem beliebigen Potential, das heißt mit der Masse M oder einem anderen Potential, beispielsweise einer niedrigeren Spannung im Kraftfahrzeug, so wirkt sich dieses auf das Potential UP des Prüfsignals PPV aus und ein Vergleich des Potentials UP mit einem für dieses vorgesehenen Sollwert SB ermöglicht es, dies zu erkennen und durch die Überwachungsschaltung 48PV ein Defektsignal D auszulösen.

Ein derartiger Schluß mit einem beliebigen Potential, das heißt Masse oder einer anderen Spannung, wirkt sich aber auch auf die Flanke beim Übergang von dem Potential UP₁ zum Potential UP₂ oder umgekehrt aus, so daß auch eine Auswertung durch Abtastung der Flanken, während der Zeitpunkte t1 bis t6 gemäß Fig. 13 oder während der Zeitpunkte t'₁ bis t'ₙ und t'ₘ bis t'_{z} gemäß Fig. 14 Aufschluß hierüber geben kann.

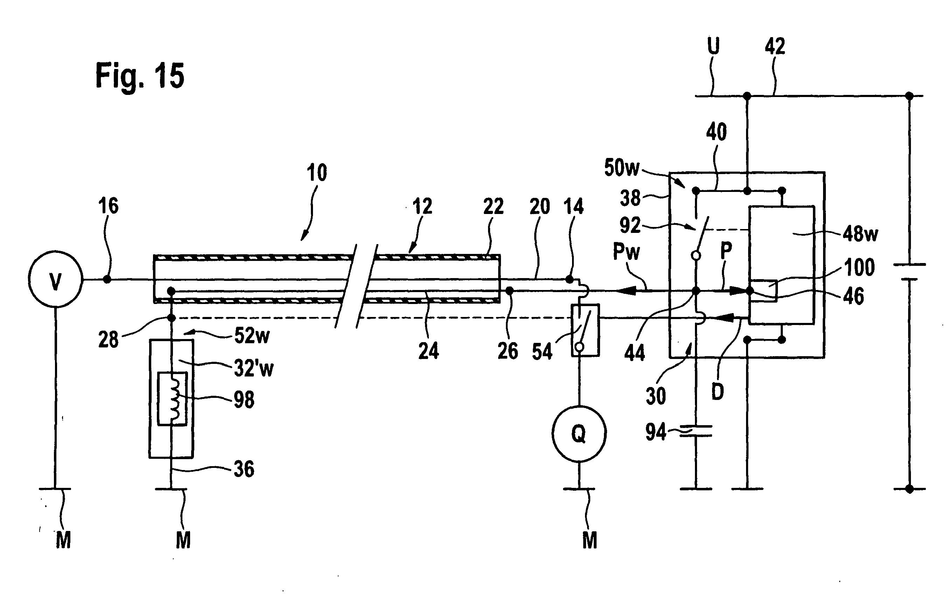

Bei einem elften Ausführungsbeispiel, dargestellt in Fig. 15, umfaßt der erste Zweig 50W lediglich den Schalter 92 und das Abschlußelement 32W umfaßt eine Induktivität 98 alternativ oder ergänzend zu dem Widerstand 34.

Ferner ist zusätzlich ebenfalls auch noch der Kondensator 94 zwischen dem Mittelabgriff 44 und Masse M vorhanden.

Dadurch ist das Detektorleitungssystem 24 Teil eines Schwingkreises, der nun entweder durch getaktetes Schalten des Schalters 92 mit Rechteckpulsen angeregt werden kann oder durch Betreiben des Schwingkreises mit einer Wechselspannung U, wobei in diesem Fall der Schalter 92 die Möglichkeit schafft, den Schwingkreis bei geschlossenem Schalter 92 anzuregen und bei geöffnetem Schalter 92 frei schwingen zu lassen.

Die Überwachungsschaltung 48W überwacht dann die resultierende Resonanzfrequenz über Bandfilter 100. Jede Veränderung der Eigenschaften des Detektorleitungssystems 24 und insbesondere eine Abkopplung einzelner Abschlußelemente 32 oder ein Schluß des Detektorleitungssystems 24 mit einem beliebigen Potential wird dann dazu führen, daß sich die Resonanzfrequenz ändert und dies läßt sich durch die Frequenzanalyse über die Bandfilter 100 feststellen.

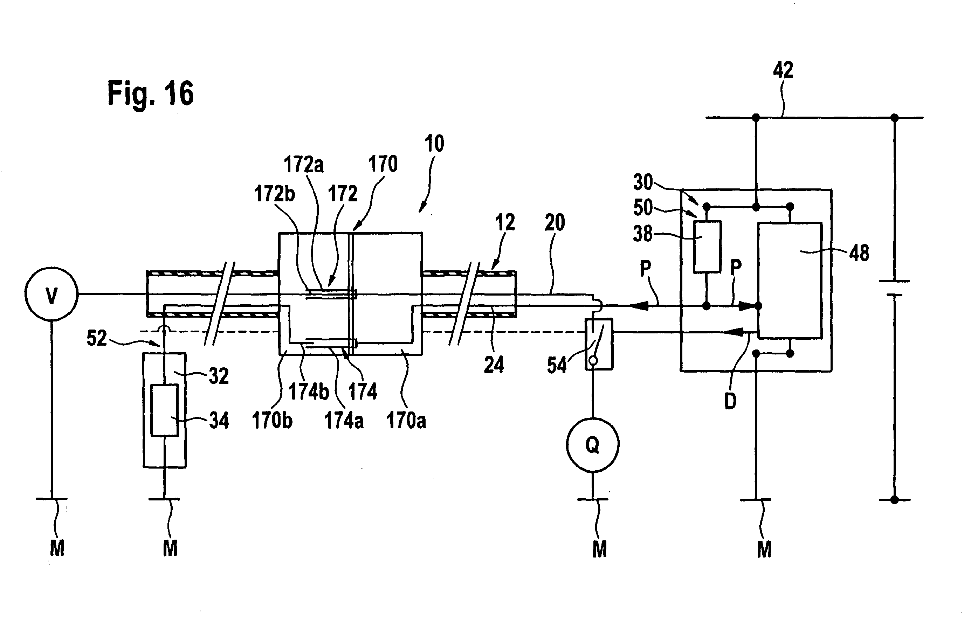

Ein zwölftes Ausführungsbeispiel, dargestellt in Fig. 16, basiert auf dem ersten Ausführungsbeispiel, allerdings ist in dem Versorgungsleitungssystem 12 eine Steckverbindung 170 mit zwei voneinander lösbaren Steckverbinderelementen 170a und 170b vorgesehen.

Das Steckverbinderelement 170a trägt dabei Kontaktelemente 172a und 174a die mit entsprechenden Kontaktelementen im Steckverbinderelement 170b, nämlich mit den Kontaktelementen 172b und 174b in Steckverbindung bringbar sind.

Vorzugsweise sind dabei die in dem stromführenden Leitungsstrang angeordneten Kontaktelemente 172a und 172b des Steckkontakts 172 derart ausgebildet und an den Steckverbinderelementen 170a und 170b angeordnet, daß diese beim Zusammenstecken vor den in dem Detektorleitungsstrang 24 angeordneten Kontaktelementen 174a und 174b des Steckkontakts 174 in Kontakt kommen und beim Lösen der Steckverbinderelemente 170a und 170b zuerst bei den Kontaktelementen 174a und 174b die elektrische Verbindung gelöst wird, bevor die elektrische Verbindung zwischen den Kontaktelementen 172a und 172b gelöst wird.

Da die Kontaktelemente 174a und 174b im Detektorleitungssystem 24 angeordnet sind führt dies dazu, daß beim Zusammenstecken der Steckverbinderelemente 170a und 170b zuerst die Kontaktelemente 172a und 172b in Kontakt kommen und somit eine elektrische Verbindung im Leitungsstrang 20 hergestellt wird bevor in dem Detektorleitungssystem 24 durch Herstellen der elektrischen Verbindung zwischen den Kontaktelementen 174a und 174b der zweite Zwei 52 des Spannungsteilers vervollständigt und somit funktionsfähig wird.

Andererseits wird beim Lösen der Steckverbinderelemente 170a und 170b das Detektorleitungssystem 24 aufgrund des vorauseilenden Lösens der Kontaktelemente 174a und 174b unterbrochen, bevor eine elektrische Unterbrechung durch Trennen der Kontaktelemente 172a und 172b im Leitungsstrang 20 erfolgt.

Durch eine derartige Ausbildung des Steckverbinders 170 wird die sichere Verbindung der Steckverbinderelemente 170a und 170b zwangsläufig ebenfalls durch die Überwachungsschaltung 48 überwacht, da ein unbeabsichtigtes Trennen der Steckverbinderelemente 170a und 170b aufgrund der vorzeitigen Lösens der Kontaktelemente 174a und 174b gegenüber dem Lösen der Kontaktelemente 172a und 172b vor einer elektrischen Trennung im Leitungsstrang 20 zu einem Defektsignal D führt, so daß die Versorgung des Leitungsstrangs 20 durch die Trennschaltung 54 unterbrochen wird. Damit wird verhindert, daß die Kontaktelemente 172a und 172b beim Stromfluß zu dem Verbraucher V voneinander getrennt werden und sich somit ein Lichtbogen aufgrund der hohen Spannung ausbildet.

In gleicher Weise liefert die Überwachungsschaltung bei getrennten Steckverbinderelementen 170a und 170b so lange das Defektsignal D, bis eine sichere Verbindung zwischen den Kontaktelementen 172a und 172b besteht, da die Kontaktelemente 174a und 174b erst zeitlich verzögert miteinander in elektrischen Kontakt kommen und das Defektsignal D durch Komplettierung des Detektorleitungssystems 24 immer erst dann entfallen lassen, wenn bereits längst eine sichere elektrische Verbindung zwischen den Kontaktelementen 172a und 172b im Leitungsstrang 20 besteht, so daß auch beim Zusammenstecken der Kontaktelemente 172a und 172b kein Lichtbogen entstehen kann.

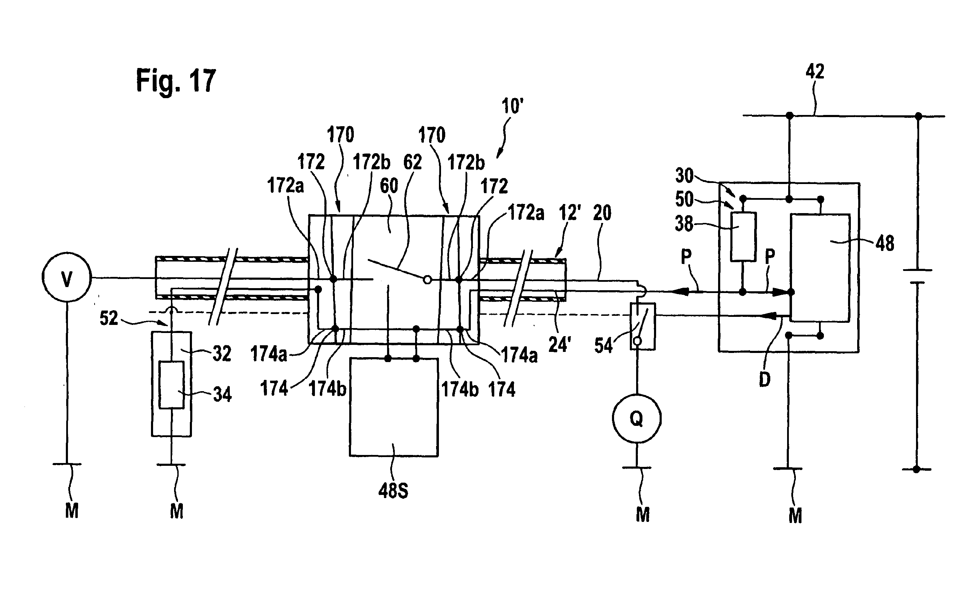

Ein in Fig. 17 dargestelltes dreizehntes Ausführungsbeispiel basiert auf dem dritten Ausführungsbeispiel gemäß Fig. 4, so daß bezüglich der Beschreibung der nicht im einzelnen erwähnten Teile auf die Ausführungen zum dritten Ausführungsbeispiel vollinhaltlich Bezug genommen wird.

Das Steuergerät 60 ist beim dreizehnten Ausführungsbeispiel nicht unmittelbar in das Versorgungsleitungssystem 12' eingebunden, sondern über im Zusammenhang mit dem zwölften Ausführungsbeispiel beschriebene Steckverbinder 170 in das Versorgungsleitungssystem 12' eingebunden.

Die Steckverbinder 170 weisen jeweils einen Steckkontakt 172 mit Kontaktelementen 172a und 172b sowie einen Steckkontakt 174 mit Kontaktelementen 174a und 174b auf, die in gleicher Weise ausgebildet sind, wie dies im Zusammenhang mit dem zwölften Ausführungsbeispiel beschrieben wurde.

Ferner ist dem Steuergerät 60 eine eigene Überwachungsschaltung 48S zugeordnet, welche das Vorliegen der Prüfsignale P im Detektorleitungssystem 24' unabhängig von der Überwachungsschaltung 48 überwacht und bei Nichtvorliegen eines korrekten Prüfsignals den Schalter 62 derart ansteuert, daß dieser öffnet.

Somit läßt sich unabhängig von der Überwachungsschaltung 48 durch die eigene Überwachungsschaltung 48S des Steuergeräts 60 sicherstellen daß der zum Verbraucher V führende Leitungsstrang 20 durch den Schalter 62 unterbrochen wird, sobald einer der Steckverbinder 170 am Steuergerät 60 gelöst wird.

Damit ist sichergestellt, daß bei beiden Steckverbindern 170 des Steuergeräts 60 ein Lösen der Kontaktelemente 172a und 172b immer in einem Zustand erfolgt, in welchem durch den Leitungsstrang 20 kein Strom zum Verbraucher V fließt, so daß ausgeschlossen werden kann, daß sich beim Trennen der Kontaktelemente 172a und 172b ein Lichtbogen ausbildet.

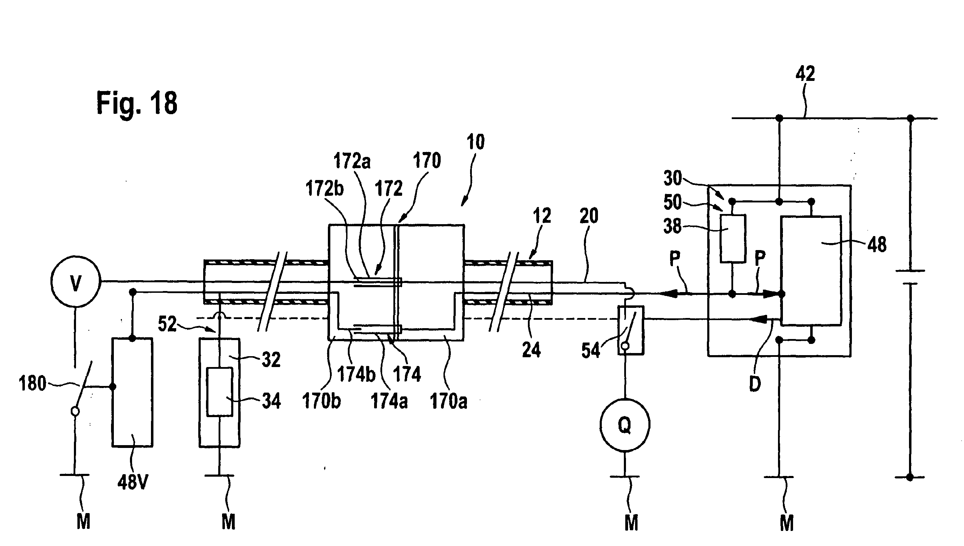

Ein vierzehntes Ausführungsbeispiel, dargestellt in Fig. 18, basiert auf dem zwölften Ausführungsbeispiel, dargestellt in Fig. 16.

Bei dem vierzehnten Ausführungsbeispiel ist dem Verbraucher V eine eigene Überwachungsschaltung 48V zugeordnet, welche überwacht, ob auf Seiten des Verbrauchers V das Prüfsignal P in korrekter Weise vorliegt.

Liegt dieses Prüfsignal P nicht vor, beispielsweise deshalb, weil der in gleicher Weise wie beim zwölften Ausführungsbeispiel ausgebildete Steckverbinder 170 getrennt wird, so betätigt die Überwachungsschaltung 48V beispielsweise einen Masseschalter 180, welcher den Verbraucher V von der Masse trennt, und zwar bevor die Kontaktelemente 172a und 172b den Leitungsstrang 20 unterbrechen, so daß die Unterbrechung des Leitungsstrangs 20 durch die Kontaktelemente 172a und 172b ohne Lichtbogenbildung erfolgen wird.

Die Überwachungsschaltung 48V arbeitet beispielsweise unabhängig von der Überwachungsschaltung 48, so daß gegebenenfalls auch die Überwachungsschaltung 48 und die Trennschaltung 54 dann entfallen können, wenn lediglich die korrekte elektrische Verbindung am Steckverbinder 170 überwacht werden soll, allerdings mit dem Nachteil, daß bei getrenntem Steckverbinder 170 auf dem zu dem Kontaktelement 172 führenden Leitungsstrang und auf dem Kontaktelement 172 noch die volle Spannung der Quelle Q anliegt.

Bei dem zwölften, dreizehnten und vierzehnten Ausführungsbeispiel ist die Überwachung der Steckverbinder 170 in das Detektorleitungssystem 24 eingebunden und somit sind ergänzend zur Überwachung der Steckverbinder 170 auch die in den voranstehenden Ausführungsbeispielen durch das Detektorleitungssystem 24 und die Detektorschaltung 30 bestehenden Vorteile vorhanden.

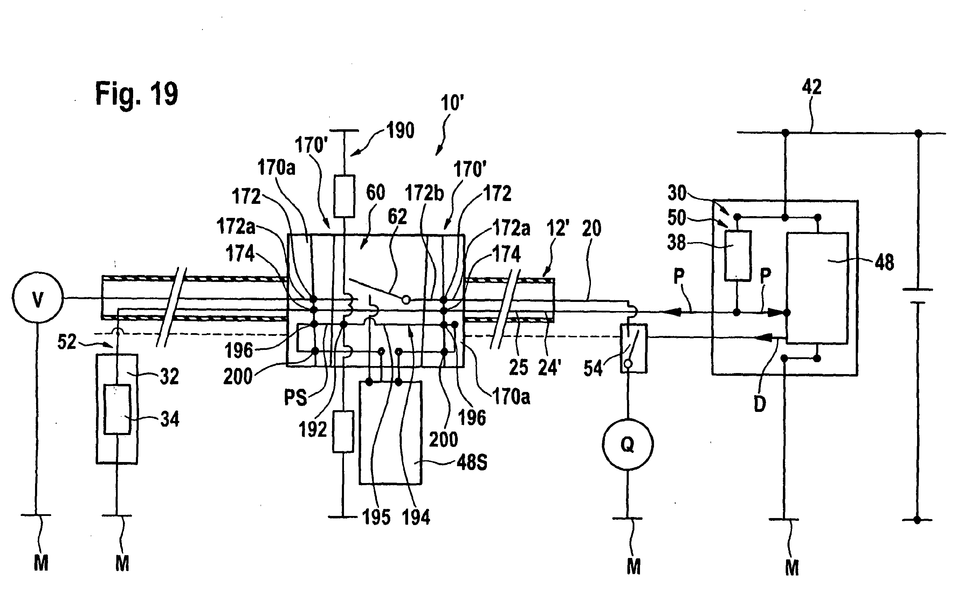

Bei einem fünfzehnten Ausführungsbeispiel, dargestellt in Fig. 19, welches auf dem Konzept des dreizehnten Ausführungsbeispiels gemäß Fig. 17 basiert, ist das Detektorleitungssystem 24' über den Steckkontakt 174 durch die Steckverbinder 170' durchgeführt.

Zusätzlich ist dem Steuergerät 60 ein eigener Spannungsteiler 190 zugeordnet, an dessen Mittelabgriff 192 ein eigenes Prüfsignal PS generierbar ist.

Dieses Prüfsignal PS wird von dem Steuergerät 60 über ein Überwachungsleitungssystem 194 umfassend eine Überwachungsleitung 195, Steckkontakte 196 und eine Schleife 196 im Steckverbinderelement 170a sowie Steckkontakten 200 zu getrennten Eingängen 202 und 204 der Überwachungsschaltung 48S geführt, wobei die Steckkontakte 196 entsprechend den Steckkontakten 172 und die Steckkontakte 200 entsprechend den Steckkontakten 174, ausgebildet sind.

Sobald nun die Steckverbinder 170' nicht korrekt verbunden sind, fehlt es an einer elektrisch leitenden Verbindung an den Steckkontakten 200 und somit schaltet die Überwachungsschaltung 48S so lange über den Schalter 62 den Verbraucher V ab, bis das Prüfsignal PS ebenfalls von der Überwachungsschaltung 48S an beiden Eingängen 202 und 204 detektiert wird.

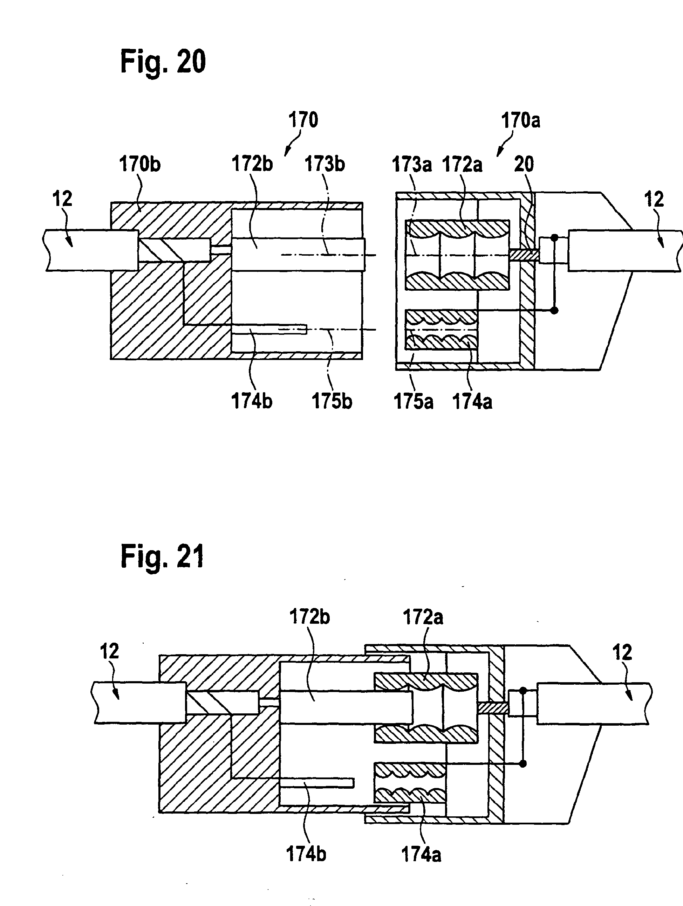

Ein Ausführungsbeispiel eines Steckverbinders 170 ist in den Fig. 20 bis 23 in seinen einzelnen Funktionsstellungen dargestellt.

Wie in Fig. 20 erkennbar, umfaßt der Steckverbinder 170 im Steckverbinderelement 170a ein als Hülse ausgebildetes Kontaktelement 172a, welches so dimensioniert ist, daß dieses auf das zylinderförmig ausgebildete Kontaktelement 172b aufschiebbar ist.

Ferner ist auch das im Steckverbinderelement 170a angeordnete Kontaktelement 174a hülsenförmig ausgebildet und auf das zylinderförmig ausgebildete Kontaktelement 174b aufschiebbar, wobei die Kontaktelemente 172a und 174a mit ihren Mittelachsen 173a und 175a parallel zueinander ausgerichtet sind und außerdem auch die Kontaktelemente 172b und 174b mit ihren Mittelachsen 173b und 175b ebenfalls parallel zueinander ausgerichtet sind und die Mittelachsen 173a und 175a sowie 173b und 175b jeweils denselben Abstand voneinander aufweisen.

Werden daher die Kontaktelemente 172a und 172b hinsichtlich ihrer Mittelachsen 173a und 173b fluchtend zueinander ausgerichtet und außerdem auch die Kontaktelemente 174a und 174 hinsichtlich ihrer Mittelachsen 175a und 175b fluchtend zueinander ausgerichtet, so lassen sich, wie in Fig. 21 dargestellt, zunächst die Kontaktelemente 172a und 172b in Kontakt bringen, während die Kontaktelemente 174a und 174b noch keinen Kontakt haben, da die Erstreckung des Kontaktelements 174b in Richtung seiner Mittelachse 175b geringer ist als die des Kontaktelements 172b.

Somit wird zunächst lediglich ein elektrischen Kontakt zwischen den mit dem Leitungsstrang 20 verbundenen Kontaktelementen 172a und 172b hergestellt.

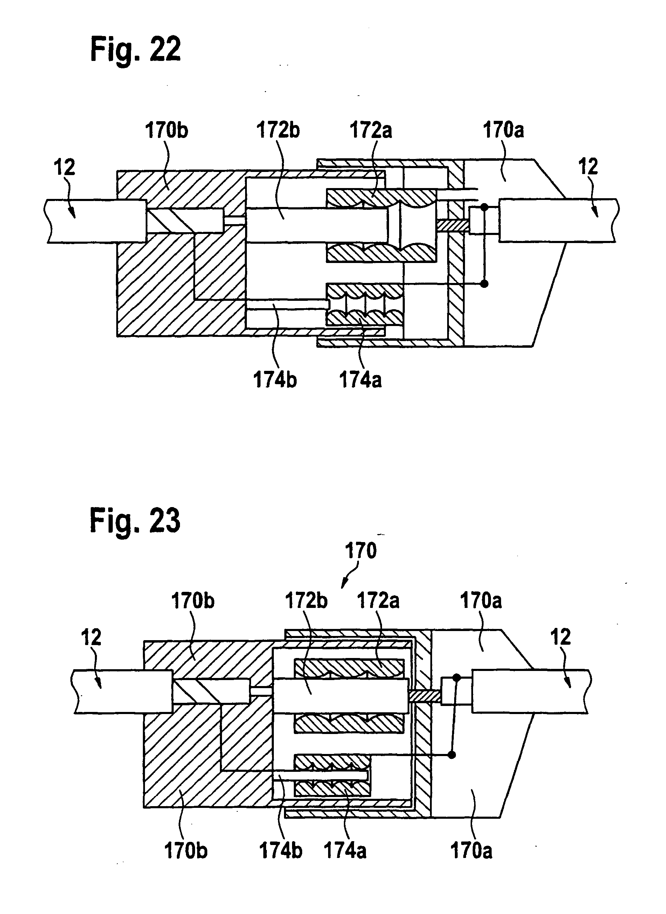

Beim weiteren Aufschieben läßt sich dann, wie in Fig. 22 dargestellt, ein erster elektrischer Kontakt zwischen den Kontaktelementen 174a und 174 erst dann herstellen, wenn bereits ein ausreichend stabiler Kontakt zwischen den Kontaktelementen 172a und 172b besteht und bei vollständig zusammengeschobenen Steckverbinderelementen 170a und 170b besteht ein langzeitstabiler Kontakt zwischen den Kontaktelementen 172a und 172b sowie 174a und 174b, wie in Fig. 23 dargestellt.

Desgleichen erfolgt beim Trennen der Steckkontaktelemente 170a und 170b voneinander zuerst eine Trennung zwischen den Kontaktelementen 174a und 174b, wie in Fig. 22 und 21 dargestellt, und erst nachfolgend eine Trennung zwischen den Kontaktelementen 172a und 172b.

Bei einer weiteren Ausführungsform eines bei dem fünften Ausführungsbeispiel gemäß Fig. 6 einsetzbaren Steckverbinders 70' ist ebenfalls im Steckverbinderelement 70'a der Schalter 64 angeordnet, der über den mechanischen Stößel 76 betätigbar ist.

Bei dieser Ausführungsform tastet der Schalter 64 jedoch nicht den sicheren Sitz der Steckverbinderelemente 70'a und 70'b relativ zueinander ab, sondern tastet eine als Ganzes mit 180 bezeichnete Verriegelungsvorrichtung ab, die einen über einen Schieber 182 betätigbaren Schieberiegel 184 umfaßt, welcher mit dem Schieber 182 in einer Verschieberichtung 186 verschiebbar im Steckverbinderelement 70'a gelagert ist.

Der Schieberiegel 184 ist dabei in der Lage in eine Riegelausnehmung 188 eines Vorsprungs 190 des Kontaktverbinderelements 70b einzugreifen, um die Kontaktverbinderelemente 70'a und 70'b mechanisch fest miteinander zu verbinden. Dabei ist über den Stößel 76 der Schalter 64 dann geschlossen, wenn der Schieberiegel 184 in die Riegelausnehmung 188 eingreift, so daß die Steckverbinderelemente 70'a und 70'b mechanisch fest miteinander verbunden sind.

Wird jedoch der Schieberiegel 184 durch Betätigen des Schiebers 182 in der Verschieberichtung 186 verschoben und kommt außer Eingriff mit der Riegelausnehmung 188, so wird über den Stößel 76 der Schalter 64 nicht mehr in seiner geschlossenen Stellung gehalten, sondern der Schalter 64 öffnet.

Das Öffnen des Schalter 64 hat dann zur Folge, daß die Überwachungsschaltung 48 das Defektsignal D erzeugt und somit mittels der Trennschaltung 54 den Stromeinspeiseanschluß 14 von der Stromquelle Q trennt, so daß der Leitungsstrang 20 nicht mehr stromführend ist, wie dies im Detail im Zusammenhang mit dem fünften Ausführungsbeispiel und den übrigen voranstehenden Ausführungsbeispielen beschrieben wurde.

Der Schieber 182 kann dabei in unterschiedlicher Art und Weise betätigt werden.

Vorzugsweise ist der Schieber 182 über einen Schieberkopf 192 betätigbar, welcher von einer Feder 194 druckbeaufschlagt ist und durch diese in einer Stellung gehalten wird, welche bewirkt, daß der Schieberiegel 184 das Bestreben hat, mit der Riegelausnehmung 188 in Eingriff zu bleiben, es sei denn, daß eine manuelle Einwirkung auf den Schieberkopf 192 der Feder 194 entgegenwirkt.

Bei diesem Steckverbinder 70' können vorzugsweise auch noch die Kontakte 72 und 74 entsprechend den Kontaktelementen 172 und 174, beschrieben im Zusammenhang mit den Fig. 20 bis 23, ausgebildet und angeordnet sein, so daß zusätzlich noch beim Zusammenstecken der Steckverbinderelemente 70'a und 70'b zunächst die Kontaktelemente 72a und 72b eine elektrisch leitende Verbindung miteinander eingehen, bevor die Kontaktelemente 74a und 74b in elektrische Verbindung miteinander kommen.

Ferner ist bei diese Ausbildung der Kontaktelemente 72 und 74 auch beim Trennen der Steckverbinderelemente 70'a und 70'b vorgesehen, daß zuerst eine Trennung der elektrischen Verbindung zwischen den Kontaktelementen 74a und 74b erfolgt, bevor eine elektrische Trennung der Kontaktelemente 72a und 72b erfolgt.

Somit kann zusätzlich durch eine derartige Ausbildung und Anordnung der Kontaktelemente 72a und 72b sowie 74a und 74b entsprechend den Kontaktelementen 172a und 172b sowie 174a und 174b sichergestellt werden, daß unabhängig von der Stellung des Schalters 64 noch eine zusätzliche Sicherheit beim Zusammenstecken der Steckverbinderelemente 70'a und 79'b gegeben ist.

Im übrigen wird zur Beschreibung der Teile und der Funktion dieses Steckverbinders 70' auf die Ausführungen im Zusammenhang mit den voranstehenden Ausführungsbeispielen vollinhaltlich Bezug genommen.

## Patentansprüche

1. Elektrisches Versorgungsnetzwerk für Bordnetze von Fahrzeugen, umfassend mindestens ein Netzwerksystem (10) mit einem Stromeinspeiseanschluss (14), mit mindestens einem Verbraucheranschluss (16) und mit einem von dem Stromeinspeiseanschluss (14) zu dem mindestens einem Verbraucheranschluss (16) geführten Versorgungsleitungssystem (12), welches mindestens einen stromführenden Leitungsstrang (20), mindestens einen diesen umgebenden Schutzmantel aufweist, und mit einem Detektorleitungssystem (24) versehen ist, eine Detektorschaltung (30) welche mit einem ersten Ende (26) des Detektorleitungssystems (24) verbunden ist ein Abschlusselement (32), welches an mindestens einem weiteren Ende (28) des Detektorleitungssystems (24) vorgesehen und mit dem Detektorleitungssystem (24) verbunden ist, wobei die Detektorschaltung (30) ein Prüfsignal (P) erzeugt, welches im defektfreien Zustand durch das Detektorleitungssystem (24) und das Abschlusselement (32) beeinflusst ist, und wobei die Detektorschaltung (30) einen Defekt durch Abweichung des Prüfsignals (P) von einem dem defektfreien Zustand entsprechenden Sollwertbereich (SB) erfasst, **dadurch gekennzeichnet, dass** das Detektorleitungssystem (24) so konzipiert ist, dass dieses beim Auftreten eines vom stromführenden Leitungsstrang ausgehenden lokalen Lichtbogens seine elektrischen Eigenschaften irreversibel verändert, so dass das Prüfsignal (P) außerhalb des Sollwertbereichs (SB) liegt, so dass ein Defekt erkannt wird, und dass die Detektorschaltung (30) beim Erfassen eines Defekts ein Trennen des Versorgungsleitungssystems (12) von der Stromquelle (Q) auslöst.

2. Versorgungsnetzwerk nach Anspruch 1, **dadurch gekennzeichnet, dass** die Detektorschaltung (30) eine Trennschaltung (54) zum Abtrennen des Versorgungsleitungssystems (12) von der Stromquelle (Q) ansteuert.

3. Versorgungsnetzwerk nach einem der voranstehenden Ansprüche, **dadurch gekennzeichnet, dass** jedes weitere Ende (28a, 28b, 28c) des Detektorleitungssystems (24) mit einem Abschlusselement (32a, 32b, 32c) versehen ist.

4. Versorgungsnetzwerk nach einem der voranstehenden Ansprüche, **dadurch gekennzeichnet, dass** das Detektorleitungssystem (24) gegenüber dem stromführenden Leitungsstrang (20) elektrisch isoliert verläuft und dem stromführenden Leitungsstrang (20) im Wesentlichen folgt.

5. Versorgungsnetzwerk nach Anspruch 4, **dadurch gekennzeichnet, dass** das Detektorleitungssystem (24) längs des stromführenden Leitungsstrangs (20) verläuft.

6. Versorgungsnetzwerk nach Anspruch 4 oder 5, **dadurch gekennzeichnet, dass** das Detektorleitungssystem (24) im Wesentlichen um den stromführenden Leitungsstrang (20) herum verläuft.

7. Versorgungsnetzwerk nach einem der voranstehenden Ansprüche, **dadurch gekennzeichnet, dass** im defektfreien Zustand das Abschlusselement (32) das Prüfsignal (P) in einem stärkeren Maß beeinflusst als das Detektorleitungssystem.

8. Versorgungsnetzwerk nach Anspruch 7, **dadurch gekennzeichnet, dass** das Abschlusselement (32) das Prüfsignal (P) um mindestens einen Faktor zehn stärker beeinflusst als das Detektorleitungssystem (20).

9. Elektrisches Versorgungsnetzwerk nach Anspruch 7 oder 8, **dadurch gekennzeichnet, dass** das Abschlusselement (32) das Prüfsignal (P) um mindestens einen Faktor 50 stärker beeinflusst als das Detektorleitungssystem.

10. Versorgungsnetzwerk nach einem der voranstehenden Ansprüche, **dadurch gekennzeichnet, dass** das Abschlusselement (32) einen elektrischen Widerstand (34) umfasst.

11. Versorgungsnetzwerk nach einem der voranstehenden Ansprüche, **dadurch gekennzeichnet, dass** das Abschlusselement (32) einen elektrischen Schalter (64) umfasst.

12. Versorgungsnetzwerk nach Anspruch 11, **dadurch gekennzeichnet, dass** der elektrische Schalter (64) ein Zustandsanzeiger für Defekte einer Verbindung des Versorgungsleitungssystems (12) zu nachfolgenden Einheiten dient.

13. Versorgungsnetzwerk nach Anspruch 11 oder 12, **dadurch gekennzeichnet, dass** der elektrische Schalter (64) mechanisch steuerbar ist.

14. Versorgungsnetzwerk nach Anspruch 12 oder 13, **dadurch gekennzeichnet, dass** der elektrische Schalter (64) elektrisch steuerbar ist.

15. Elektrisches Versorgungsnetzwerk nach Anspruch 14, **dadurch gekennzeichnet, dass** der elektrische Schalter (64) durch eine Detektorschaltung (3O₂) eines nachfolgenden Versorgungsleitungssystems (12₂) steuerbar ist.

16. Versorgungsnetzwerk nach einem der voranstehenden Ansprüche, **dadurch gekennzeichnet, dass** die Detektorschaltung (30) mit dem Prüfsignal (P) einen von dem Detektorleitungssystem (24) und dem Abschlusselement (32) bestimmten elektrischen Widerstand erfasst.

17. Versorgungsnetzwerk nach Anspruch 16, **dadurch gekennzeichnet, dass** die Detektorschaltung (30) den elektrischen Widerstand gegen Masse (M) detektiert.

18. Versorgungsnetzwerk nach Anspruch 16 oder 17, **dadurch gekennzeichnet, dass** das Abschlusselement (32) zwischen dem weiteren Ende des Detektorleitungssystems (24) und Masse (M) liegt.

19. Versorgungsnetzwerk nach einem der voranstehenden Ansprüche, **dadurch gekennzeichnet, dass** das Prüfsignal (P) durch einen Spannungsteiler (50, 52) erzeugbar ist.

20. Versorgungsnetzwerk nach Anspruch 19, **dadurch gekennzeichnet, dass** das Abschlusselement (32) ein Element des Spannungsteilers (50, 52) ist.

21. Versorgungsnetzwerk nach Anspruch 19 oder 20, **dadurch gekennzeichnet, dass** das Detektorleitungssystem (24) ein Element des Spannungsteilers (50, 52) ist.

22. Versorgungsnetzwerk nach einem der Ansprüche 19 bis 21, **dadurch gekennzeichnet, dass** die Detektorschaltung (30) einen von dem ersten Ende (26) des Detektorleitungssystems (24) zu einer Spannungsversorgung (42) führenden ersten Zweig (50) eines Spannungsteilers zur Erzeugung des Prüfsignals umfasst.

23. Versorgungsnetzwerk nach einem der Ansprüche 19 bis 22, **dadurch gekennzeichnet, dass** das Abschlusselement (32) und das Detektorleitungssystem (24) einen zweiten Zweig (52) des Spannungsteilers bilden.

24. Versorgungsnetzwerk nach Anspruch 23, **dadurch gekennzeichnet, dass** der zweite Zweig (52) des Spannungsteilers zwischen dem ersten Ende (26) des Detektorleitungssystems (24) und Masse (M) liegt.

25. Versorgungsnetzwerk nach einem der Ansprüche 19 bis 24, **dadurch gekennzeichnet, dass** die Detektorschaltung (30) als Prüfsignal (P) die Spannung am ersten Ende (26) des Detektorleitungssystems (24) überwacht.

26. Versorgungsnetzwerk nach Anspruch 25, **dadurch gekennzeichnet, dass** die Detektorschaltung (30) mit einer Überwachungsschaltung (48) ein Über- oder Unterschreiten von Spannungsschwellen erfasst.

27. Versorgungsnetzwerk nach einem der voranstehenden Ansprüche, **dadurch gekennzeichnet, dass** das Prüfsignal (P) ein Gleichspannungssignal ist.

28. Versorgungsnetzwerk nach Anspruch 27, **dadurch gekennzeichnet, dass** das Prüfsignal (PV) mehrere Gleichspannungspotentiale (UP₁, UP₂) umfasst.

29. Versorgungsnetzwerk nach Anspruch 28, **dadurch gekennzeichnet, dass** die Gleichspannungspotentiale (UP₁, UP₂) aufeinanderfolgend angelegt werden.

30. Versorgungsnetzwerk nach Anspruch 28 oder 29, **dadurch gekennzeichnet, dass** mindestens während eines Überwachungszeitraums ein Wechsel zwischen den Gleichspannungspotentialen (UP₁, UP₂) erfolgt.

31. Versorgungsnetzwerk nach einem der Ansprüche 28 bis 30, **dadurch gekennzeichnet, dass** die Überwachungsschaltung (48V) Differenzen zwischen den Gleichspannungspotentialen (UP₁, UP₂) auswertet.

32. Versorgungsnetzwerk nach einem der Ansprüche 28 bis 31, **dadurch gekennzeichnet, dass** die Überwachungsschaltung (48V) einen Verlauf der Gleichspannungspotentiale (UP₁, UP₂) auswertet.

33. Versorgungsnetzwerk nach Anspruch 32, **dadurch gekennzeichnet, dass** die Überwachungsschaltung (48V) Flanken bei einer Änderung der Gleichspannungspotentiale (UP₁, UP₂) auswertet.

34. Versorgungsnetzwerk nach einem der Ansprüche 1 bis 26, **dadurch gekennzeichnet, dass** das Prüfsignal (PW) ein Wechselspannungssignal ist.

35. Versorgungsnetzwerk nach Anspruch 34, **dadurch gekennzeichnet, dass** das Prüfsignal (PW) ein hochfrequentes Wechselspannungssignal ist.

36. Versorgungsnetzwerk nach einem der Ansprüche 34 oder 35, **dadurch gekennzeichnet, dass** das Detektorleitungssystem (24) und das mindestens eine Abschlusselement (32W) Elemente eines Schwingkreises bilden.

37. Versorgungsnetzwerk nach Anspruch 36, **dadurch gekennzeichnet, dass** die Überwachungsschaltung (48W) Frequenzkomponenten des Prüfsignals (PW) auswertet.

38. Versorgungsnetzwerk nach Anspruch 37, **dadurch gekennzeichnet, dass** die Überwachungsschaltung (48W) die Frequenzkomponente über Bandfilter (100) erfasst.

39. Versorgungsnetzwerk nach einem der voranstehenden Ansprüche, **dadurch gekennzeichnet, dass** die Detektorschaltung (30) eine Überwachungsschaltung (48) mit einem Lernmodus aufweist, in welchem der Sollwertbereich (SB) für das Prüfsignal (P) ermittelbar ist.

40. Versorgungsnetzwerk nach Anspruch 39, **dadurch gekennzeichnet, dass** die Überwachungsschaltung (48) den Sollwertbereich (SB) ausgehend von einem Messwert für das Prüfsignal (P) bei defektfreiem Detektorleitungssystem (24) mit dem mindestens einem Abschlusselement (32) ermittelt.

41. Versorgungsnetzwerk nach Anspruch 39 oder 40, **dadurch gekennzeichnet, dass** der Sollwertbereich (SB) durch eine von der Überwachungsschaltung (48) erzeugte Sollwertbandbreite (Δ) festlegbar ist.

42. Versorgungsnetzwerk nach einem der voranstehenden Ansprüche, **dadurch gekennzeichnet, dass** das Versorgungsleitungssystem (12) den mindestens einen stromführenden Leitungsstrang (20) und lösbare Leistungskontaktelemente (172a, b) für den stromführenden Leistungsstrang (20) aufweist, dass ein Überwachungsleitungssystem (24, 194) vorgesehen ist, welches mindestens eine Überwachungsleitung (25, 195) und lösbare Überwachungskontaktelemente (174a, b, 200a, b) in der Überwachungsleitung (25, 195) aufweist, dass Überwachungskontaktelemente (174a, b , 200a, b) derart mit den Leistungskontaktelementen (172a, b) gekoppelt sind, dass ein Lösen der Überwachungskontaktelemente (174a, b, 200a, b) mit einem Lösen der Leistungskontaktelemente (172a, b) erfolgt und dass eine Überwachungsschaltung (48) vorgesehen ist, welche mittels eines Prüfsignals (P, PS, PV) das Überwachungsleitungssystem (24, 194) überwacht und mittels einer Abschalteinrichtung (54, 62, 180) bei gelösten Überwachungskontaktelementen (174a, b, 200a, b) einen Stromfluss durch den stromführenden Leitungsstrang (20) unterbricht.

43. Versorgungsnetzwerk nach Anspruch 42, **dadurch gekennzeichnet, dass** die Überwachungskontaktelemente (174a, b, 200a, b) derart angeordnet sind, dass die Leistungskontaktelemente (172a, b) nur dann lösbar sind, wenn die Überwachungskontaktelemente (174a,b, 200a, b) bereits kontaktfrei voneinander sind.

44. Versorgungsnetzwerk nach Anspruch 42 oder 43, **dadurch gekennzeichnet, dass** die Überwachungskontaktelemente (174a, b, 200a, b) in ihrer kontaktgebenden Stellung ein Lösen der Leistungskontaktelemente (172a, b) mechanisch blockieren.

45. Versorgungsnetzwerk nach einem der Ansprüche 42 bis 44, **dadurch gekennzeichnet, dass** die Überwachungskontaktelemente (174a, b, 200a, b) Elemente eines Steckkontakts (174, 200) sind.

46. Versorgungsnetzwerk nach einem der Ansprüche 42 bis 45, **dadurch gekennzeichnet, dass** die Leistungskontaktelemente (172a, b) Elemente eines Steckkontakts (172) sind.

47. Versorgungsnetzwerk nach einem der Ansprüche 42 bis 46, **dadurch gekennzeichnet, dass** jeweils eines der Leistungskontaktelemente (172a, b) und eines der Überwachungskontaktelemente (174a, b, 200a, b) in einem Steckverbinderelement (170a) und das andere der Leistungskontaktelemente (172a, b) und das andere der Überwachungskontaktelemente (174a, b, 200a, b) in dem anderen Steckverbinderelement (170b) eines Steckverbinders (170) angeordnet sind.

48. Versorgungsnetzwerk nach einem der Ansprüche 42 bis 47, **dadurch gekennzeichnet, dass** die Überwachungsschaltung (48) eine mechanische Verbindung der Steckverbinderelemente (70a, 70b, 70'a, 70'b) überwacht und mittels einer Abschaltung (54) bei gelöster mechanischer Verbindung einen Stromfluss durch den stromführenden Leitungsstrang (20) unterbricht.

49. Versorgungsnetzwerk nach Anspruch 48, **dadurch gekennzeichnet, dass** die Überwachungsschaltung (48) eine Verriegelungsvorrichtung (180) der Steckverbinderelemente (70'a. 70'b) überwacht.

50. Versorgungsnetzwerk nach einem der voranstehenden Ansprüche, **dadurch gekennzeichnet, dass** das Überwachungsleitungssystem durch das Detektorleitungssystem (24) gebildet ist.

## Claims

1. An electrical supply network for on-board vehicle power systems comprising at least one network system (10) having a current feed connection (14), at least one load connection (16) and a supply line system (14) leading from the current feed connection (14) to the at least one load connection (16) which has at least one current-conducting line section (20) with at least one protective sheath surrounding same and provided with a detector line system (24), a detector circuit (30) connected to a first end (26) of said detector line system (24), a terminating element (32) provided at least at one additional end (28) and connected to said detector line system (24), wherein the detector circuit (30) generates a test signal (P) which, in a defect-free state, is influenced by the detector line system (24) and the terminating element (32), and wherein the detector circuit (30) detects a malfunction when the test signal (P) deviates from a target value range (SB) corresponding to the defect-free state,
**characterized in that** the detector line system (24) is designed so as to irreversibly change its electrical properties upon the emanating of a local electric arc from the current-conducting line section so that the test signal (P) will be outside of the target value range (SB) such that a malfunction is detected, and that the detector circuit (30) triggers the disconnecting of the supply line system (12) from the power source (Q) upon a malfunction being detected.

2. The supply network according to claim 1, **characterized in that**
the detector circuit (30) controls a circuit breaker (54) to disconnect the supply line system (12) from the power source (Q).

3. The supply network according to any one of the preceding claims, **characterized in that**
each additional end (28a, 28b, 28c) of the detector line system (24) is provided with a terminating element (32a, 32b, 32c).

4. The supply network according to any one of the preceding claims, **characterized in that**
the detector line system (24) extends electrically insulated from the current-conducting line section (20) and essentially follows said current-conducting line section (20).

5. The supply network according to claim 4, **characterized in that**
the detector line system (24) extends lengthwise to the current-conducting line section (20).

6. The supply network according to claim 4 or 5, **characterized in that**
the detector line system (24) essentially extends around the current-conducting line section (20).

7. The supply network according to any one of the preceding claims, **characterized in that**
in the defect-free state, the terminating element (32) influences the test signal (P) to a greater extent than the detector line system.

8. The supply network according to claim 7, **characterized in that**
the terminating element (32) influences the test signal (P) to a greater extent than the detector line system (20) by at least a factor of ten.

9. The supply network according to claim 7 or 8, **characterized in that**
the terminating element (32) influences the test signal (P) to a greater extent than the detector line system (20) by at least a factor of 50.

10. The supply network according to any one of the preceding claims, **characterized in that**
the terminating element (32) comprises an electrical resistor (34).

11. The supply network according to any one of the preceding claims, **characterized in that**
the terminating element (32) comprises an electrical switch (64).

12. The supply network according to claim 11, **characterized in that**
the electrical switch (64) serves as a status indicator for a malfunctioning connection between the supply line system (12) and subsequently-provided units.

13. The supply network according to claim 11 or 12, **characterized in that**
the electrical switch (64) can be controlled mechanically.

14. The supply network according to claim 12 or 13, **characterized in that**
the electrical switch (64) can be controlled electrically.

15. The electrical supply network according to claim 14, **characterized in that**
the electrical switch (64) can be controlled by a detector circuit (30₂) of a subsequently-provided supply line system (12₂).

16. The supply network according to any one of the preceding claims, **characterized in that**
the detector circuit (30) uses the test signal (P) to detect an electrical resistance determined by the detector line system (24) and the terminating element (32).

17. The supply network according to claim 16, **characterized in that**
the detector circuit (30) detects the electrical resistance relative to ground (M).

18. The supply network according to claim 16 or 17, **characterized in that**
the terminating element (32) is situated between the further end of the detector line system (24) and ground (M).

19. The supply network according to any one of the preceding claims, **characterized in that** the test signal (P) can be generated by a voltage divider (50, 52).

20. The supply network according to claim 19, **characterized in that**
the terminating element (32) is an element of the voltage divider (50, 52).

21. The supply network according to claim 19 or 20, **characterized in that**
the detector line system (24) is an element of the voltage divider (50, 52).

22. The supply network according to any one of claims 19 to 21, **characterized in that** the detector circuit (30) comprises a first branch (50) of a voltage divider for generating the test signal which leads from the first end (26) of the detector line system (24) to a voltage supply (42).

23. The supply network according to any one of claims 19 to 22, **characterized in that** the terminating element (32) and the detector line system (24) form a second branch (52) of the voltage divider.

24. The supply network according to claim 23, **characterized in that**
the second branch (52) of the voltage divider is situated between the first end (26) of the detector line system (24) and ground (M).

25. The supply network according to any one of claims 19 to 24, **characterized in that** the detector circuit (30) monitors the voltage at the first end (26) of the detector line system (24) as the test signal (P).

26. The supply network according to claim 25, **characterized in that**
the detector circuit (30) uses a monitoring circuit (48) to detect any exceeding or falling short of voltage thresholds.

27. The supply network according to any one of the preceding claims, **characterized in that**
the test signal (P) is a direct current voltage signal.

28. The supply network according to claim 27, **characterized in that**
the test signal (PV) comprises a plurality of direct current voltage potentials (UP₁, UP₂).

29. The supply network according to claim 28, **characterized in that**
the direct current voltage potentials (UP₁, UP₂) are applied successively.

30. The supply network according to claim 28 or 29, **characterized in that**
a change in direct current voltage potential (UP₁, UP₂) occurs at least during the course of one monitoring period.

31. The supply network according to any one of claims 28 to 30, **characterized in that** the monitoring circuit (48V) evaluates the differences between the direct current voltage potentials (UP₁, UP₂).

32. The supply network according to any one of claims 28 to 31, **characterized in that** the monitoring circuit (48V) evaluates a characteristic of the direct current voltage potentials (UP₁, UP₂).

33. The supply network according to claim 32, **characterized in that**
the monitoring circuit (48V) evaluates transition edges upon a change in the direct current voltage potentials (UP₁, UP₂).

34. The supply network according to any one of claims 1 to 26, **characterized in that** the test signal (PW) is an alternating voltage signal.

35. The supply network according to claim 34, **characterized in that**
the test signal (PW) is a high-frequency alternating voltage signal.

36. The supply network according to any one of claims 34 or 35, **characterized in that** the detector line system (24) and the at least one terminating element (32W) form elements of an oscillating circuit.

37. The supply network according to claim 36, **characterized in that**
the monitoring circuit (48W) evaluates the frequency components of the test signal (PW).

38. The supply network according to claim 37, **characterized in that**
the monitoring circuit (48W) detects the frequency components via band filters (100).

39. The supply network according to any one of the preceding claims, **characterized in that**
the detector circuit (30) comprises a monitoring circuit (48) having a learning mode in which the target value range (SB) for the test signal (P) can be established.

40. The supply network according to claim 39, **characterized in that**
in the case of a defect-free detector line system (24), the monitoring circuit (48) uses the at least one terminating element (32) to establish the target value range (SB) based on a measured value for the test signal (P).

41. The supply network according to claim 39 or 40, **characterized in that**
the target value range (SB) can be established by means of a target value bandwidth (Δ) generated by the monitoring circuit (48).

42. The supply network according to any one of the preceding claims, **characterized in that**
the supply line system (12) comprises the at least one current-conducting line section (20) and disconnectable power contact elements (172a,b) for the current-conducting line section (20), that a monitoring line system (24, 194) is provided which comprises at least one monitoring line (25, 195) and disconnectable monitoring contact elements (174a,b, 200a,b) in said monitoring line (25, 195), that the monitoring contact elements (174a,b, 200a,b) are coupled to the power contact elements (172a,b) such that a disconnecting of the monitoring contact elements (174a,b, 200a,b) occurs upon a disconnecting of the power contact elements (172a,b), and that a monitoring circuit (48) is provided which monitors the monitoring line system (24, 194) by means of a test signal (P, PS, PV) and which interrupts a flow of current through the current-conducting line section (20) via a tripping device (54, 62, 180) upon the monitoring contact elements (174a,b, 200a,b) being disconnected.

43. The supply network according to claim 42, **characterized in that**
the monitoring contact elements (174a,b, 200a,b) are arranged such that the power contact elements (172a,b) can only be disconnected when the monitoring contact elements (174a,b, 200a,b) are already in non-contacting position.

44. The supply network according to claim 42 or 43, **characterized in that**
the monitoring contact elements (174a,b, 200a,b) mechanically block the disconnecting of the power contact elements (172a,b) when in the contacting position.

45. The supply network according to any one of claims 42 to 44, **characterized in that** the monitoring contact elements (174a,b, 200a,b) are elements of a plug contact (174, 200).

46. The supply network according to any one of claims 42 to 45, **characterized in that** the power contact elements (172a,b) are elements of a plug contact (172).

47. The supply network according to any one of claims 42 to 46, **characterized in that** one of the power contact elements (172a,b) and one of the monitoring contact elements (174a,b, 200a,b) respectively are arranged in one plug connector element (170a) and the other of the power contact elements (172a,b) and the other of the monitoring contact elements (174a,b, 200a,b) are arranged in the other plug connector element (170b) of a plug connector (170).

48. The supply network according to any one of claims 42 to 47, **characterized in that** the monitoring circuit (48) monitors a mechanical connection of the plug connector elements (70a, 70b, 70'a, 70'b) and interrupts a flow of current through the current-conducting line section (20) by means of a trip (54) upon a mechanical connection being disconnected.

49. The supply network according to claim 48, **characterized in that**
the monitoring circuit (48) monitors a locking mechanism (180) of the plug connector elements (70'a, 70'b).

50. The supply network according to any one of the preceding claims, **characterized in that**
the monitoring line system is formed by the detector line system (24).

## Revendications

1. Réseau d'alimentation électrique pour des réseaux de bord de véhicules automobiles, comprenant au moins un système de réseau (10) avec un raccord d'alimentation de courant (14), au moins un raccord consommateur (16) et un système de ligne d'alimentation (12) qui mène du raccord d'alimentation de courant (14) audit au moins un raccord consommateur (16), et qui comprend au moins une âme de ligne (20) conduisant le courant électrique, au moins une enveloppe protectrice entourant cette âme, et un système de ligne de détecteur (24), un circuit détecteur (30) qui est relié à une première extrémité (26) du système de ligne de détecteur (24), un élément de terminaison (32), qui est prévu à au moins une autre extrémité (28) du système de ligne de détecteur (24) et qui est relié au système de ligne de détecteur (24), dans lequel le circuit détecteur (30) génère un signal de contrôle (P) qui, dans l'état exempt de défauts, est influencé par le système de ligne de détecteur (24) et par l'élément de terminaison (32), et dans lequel le circuit détecteur (30) constate un défaut par un écart du signal de contrôle (P) depuis une plage de valeurs de consigne (SB) qui correspond à l'état exempt de défauts,
**caractérisé en ce que** le système de ligne de détecteur (24) est ainsi conçu que, lors de l'apparition d'un arc électrique local partant de l'âme de ligne conduisant le courant électrique, celui-ci modifie ses propriétés électriques de manière irréversible, de sorte que le signal de contrôle (P) se trouve hors de la plage de valeurs de consigne (SB), de sorte que l'on constate un défaut, et **en ce que** lors de la constatation d'un défaut, le circuit détecteur (30) déclenche une séparation du système de ligne d'alimentation (12) vis-à-vis de la source de courant (Q).

2. Réseau d'alimentation électrique selon la revendication 1, **caractérisé en ce que** le circuit détecteur (30) pilote un circuit de séparation (54) pour séparer le système de ligne d'alimentation (12) vis-à-vis de la source de courant (Q).

3. Réseau d'alimentation électrique selon l'une des revendications précédentes, **caractérisé en ce que** chaque autre extrémité (28a, 28b, 28c) du système de ligne de détecteur (24) est pourvue d'un élément de terminaison (32a, 32b, 32c).

4. Réseau d'alimentation électrique selon l'une des revendications précédentes, **caractérisé en ce que** le système de ligne de détecteur (24) s'étend de manière électriquement isolée par rapport à l'âme de ligne (20) conduisant le courant électrique, et suit sensiblement l'âme de ligne (20) conduisant le courant électrique.

5. Réseau d'alimentation électrique selon la revendication 4, **caractérisé en ce que** le système de ligne de détecteur (24) s'étend le long de l'âme de ligne (20) conduisant le courant électrique.

6. Réseau d'alimentation électrique selon la revendication 4 ou 5, **caractérisé en ce que** le système de ligne de détecteur (24) s'étend sensiblement tout autour de l'âme de ligne (20) conduisant le courant électrique.

7. Réseau d'alimentation électrique selon l'une des revendications précédentes, **caractérisé en ce que**, dans l'état exempt de défauts de l'élément de terminaison (32), le signal de contrôle (P) est influencé dans une mesure plus forte que le système de ligne de détecteur.

8. Réseau d'alimentation électrique selon la revendication 7, **caractérisé en ce que** l'élément de terminaison (32) influence le signal de contrôle (P) plus fortement que le système de ligne de détecteur (20), et cela au moins d'un facteur dix.

9. Réseau d'alimentation électrique selon la revendication 7 ou 8, **caractérisé en ce que** l'élément de terminaison (32) influence le signal de contrôle (P) plus fortement que le système de ligne de détecteur, et cela au moins d'un facteur cinquante.

10. Réseau d'alimentation électrique selon l'une des revendications précédentes, **caractérisé en ce que** l'élément de terminaison (32) comprend une résistance électrique (34).

11. Réseau d'alimentation électrique selon l'une des revendications précédentes, **caractérisé en ce que** l'élément de terminaison (32) comprend un commutateur électrique (64).

12. Réseau d'alimentation électrique selon la revendication 11, **caractérisé en ce que** le commutateur électrique (64) sert d'indicateur d'état pour des défauts d'une liaison du système de ligne d'alimentation (12) vers des unités en aval.

13. Réseau d'alimentation électrique ouvre selon la revendication 11 ou 12, **caractérisé en ce que** le commutateur électrique (64) est susceptible d'être commandé mécaniquement.

14. Réseau d'alimentation électrique selon la revendication 12 ou 13, **caractérisé en ce que** le commutateur électrique (64) est susceptible d'être commandé électriquement.

15. Réseau d'alimentation électrique selon la revendication 14, **caractérisé en ce que** le commutateur électrique (64) est susceptible d'être commandé par un circuit détecteur (30₂) d'un système de ligne d'alimentation (12₂) en aval.

16. Réseau d'alimentation électrique selon l'une des revendications précédentes, **caractérisé en ce que** le circuit détecteur (30) constate, avec le signal de contrôle (P), une résistance électrique déterminée par le système de ligne de détecteur (24) et par l'élément de terminaison (32).

17. Réseau d'alimentation électrique selon la revendication 16, **caractérisé en ce que** le circuit détecteur (30) détecte la résistance électrique par rapport à la masse (M).

18. Réseau d'alimentation électrique selon la revendication 16 ou 17, **caractérisé en ce que** l'élément de terminaison (32) est situé entre l'autre extrémité du système de ligne de détecteur (24) et la masse (M).

19. Réseau d'alimentation électrique selon l'une des revendications précédentes, **caractérisé en ce que** le signal de commande (P) est susceptible d'être généré par un diviseur de tension (50, 52).

20. Réseau d'alimentation électrique selon la revendication 19, **caractérisé en ce que** l'élément de terminaison (32) est un élément du diviseur de tension (50, 52).

21. Réseau d'alimentation électrique selon la revendication 19 ou 20, **caractérisé en ce que** le système de ligne de détecteur (24) est un élément du diviseur de tension (50, 52).

22. Réseau d'alimentation électrique selon l'une des revendications 19 à 21, **caractérisé en ce que** le circuit détecteur (30) comprend une première ramification (50), qui mène de la première extrémité (26) du système de ligne de détecteur (24) à une alimentation électrique (42), d'un diviseur de tension pour générer le signal de contrôle.

23. Réseau d'alimentation électrique selon l'une des revendications 19 à 22, **caractérisé en ce que** l'élément de terminaison (32) et le système de ligne de détecteur (24) forment une seconde ramification (52) du diviseur de tension.

24. Réseau d'alimentation électrique selon la revendication 23, **caractérisé en ce que** la seconde ramification (52) du diviseur de tension est située entre la première extrémité (26) du système de ligne de détecteur (24) et la masse (M).

25. Réseau d'alimentation électrique selon l'une des revendications 19 à 24, **caractérisé en ce que** le circuit détecteur (30) surveille, à titre de signal de contrôle (P), la tension à la première extrémité (26) du système de ligne de détecteur (24).

26. Réseau d'alimentation électrique selon la revendication 25, **caractérisé en ce que** le circuit détecteur (30) constate, avec un circuit de surveillance (48), un passage au-dessus ou au-dessous de seuil de tension.

27. Réseau d'alimentation électrique selon l'une des revendications précédentes, **caractérisé en ce que** le signal de contrôle (P) est un signal à tension continue.

28. Réseau d'alimentation électrique selon la revendication 27, **caractérisé en ce que** le signal de contrôle (PV) comprend plusieurs potentiels de tension continue (UP₁, UP₂).

29. Réseau d'alimentation électrique selon la revendication 28, **caractérisé en ce que** les potentiels de tension continue (UP₁, UP₂) sont appliqués les uns après les autres.

30. Réseau d'alimentation électrique selon la revendication 28 ou 29, **caractérisé en ce que**, au moins pendant une durée de surveillance, a lieu un changement entre les potentiels de tension continue (UP₁, UP₂).

31. Réseau d'alimentation électrique selon l'une des revendications 28 à 30, **caractérisé en ce que** le circuit de surveillance (48V) évalue des différences entre les potentiels de tension continue (UP₁, UP₂).

32. Réseau d'alimentation électrique selon l'une des revendications 28 à 31, **caractérisé en ce que** le circuit de surveillance (48V) évalue une évolution des potentiels de tension continue (UP₁, UP₂).

33. Réseau d'alimentation électrique selon la revendication 32, **caractérisé en ce que** le circuit de surveillance (48V) évalue des flancs lors d'une modification des potentiels de tension continue (UP₁, UP₂).

34. Réseau d'alimentation électrique selon l'une des revendications 1 à 26, **caractérisé en ce que** le signal de contrôle (PW) est un signal à tension alternative.

35. Réseau d'alimentation électrique selon la revendication 34, **caractérisé en ce que** le signal de contrôle (PW) et un signal à tension alternative à haute fréquence.

36. Réseau d'alimentation électrique selon l'une des revendications 34 ou 35, **caractérisé en ce que** le système de ligne de détecteur (24) et ledit au moins un élément de terminaison (32W) forment des éléments d'un circuit oscillant.

37. Réseau d'alimentation électrique selon la revendication 36, **caractérisé en ce que** le circuit de surveillance (48W) évalue des composantes de fréquence du signal de contrôle (PW).

38. Réseau d'alimentation électrique selon la revendication 37, **caractérisé en ce que** le circuit de surveillance (48W) détecte les composantes de fréquence via des filtres passe-bande (100).

39. Réseau d'alimentation électrique selon l'une des revendications précédentes, **caractérisé en ce que** le circuit détecteur (30) comprend un circuit de surveillance (48) avec un mode d'apprentissage, dans lequel la plage de valeurs de consigne (SB) pour le signal de contrôle (P) peut être déterminée.

40. Réseau d'alimentation électrique selon la revendication 39, **caractérisé en ce que** le circuit de surveillance (48) détermine la plage de valeurs de consigne (SB) à partir d'une valeur de mesure pour le signal de contrôle (P) alors que le système de ligne de détecteur (24) est exempt de défauts avec ledit au moins un élément de terminaison (32).

41. Réseau d'alimentation électrique selon la revendication 39 ou 40, **caractérisé en ce que** la plage de valeurs de consigne (SB) est susceptible d'être déterminée par une largeur de bande de valeurs de consigne (D) engendrée par le circuit de surveillance (48).

42. Réseau d'alimentation électrique selon l'une des revendications précédentes, **caractérisé en ce que** le système de ligne d'alimentation (12) comprend ladite au moins une âme de ligne (20) conduisant le courant et des éléments de contact de puissance (172a, b) détachables pour l'âme de ligne (20) conduisant le courant, **en ce qu'**il est prévu un système de ligne de surveillance (24, 194) qui comprend au moins une ligne de surveillance (25, 195) et des éléments de contact de surveillance (174a, b, 200a, b) détachables dans la ligne de surveillance (25, 195), **en ce que** les éléments de contact de surveillance (174a, b, 200a, b) sont couplés aux éléments de contact de puissance (172a, b) de telle manière qu'un détachement des éléments de contact de surveillance (174a, b, 200a, b) a lieu avec un détachement des éléments de contact de puissance (172a, b), et **en ce qu'**il est prévu un circuit de surveillance (48) qui surveille le système de ligne de surveillance (24, 194) au moyen d'un signal de contrôle (P, PS, PV), et qui, lorsque les éléments de contact de surveillance (174a, b, 200a, b) sont détachés, interrompt un courant électrique à travers l'âme de ligne (20) conduisant le courant au moyen d'un dispositif de coupure (54, 62, 180).

43. Réseau d'alimentation électrique selon la revendication 42, **caractérisé en ce que** les éléments de contact de surveillance (174a, b, 200a, b) sont agencés de telle manière que les éléments de contact de puissance (172a, b) sont détachables uniquement quand les éléments de contact de surveillance (174a, b, 200a, b) sont déjà sans contact les uns avec les autres.

44. Réseau d'alimentation électrique selon la revendication 42 ou 43, **caractérisé en ce que** les éléments de contact de surveillance (174a, b, 200a, b), dans leur position établissant un contact, bloquent mécaniquement un détachement des éléments de contact de puissance (172a, b).

45. Réseau d'alimentation électrique selon l'une des revendications 42 à 44, **caractérisé en ce que** les éléments de contact de surveillance (174a, b, 200a, b) sont des éléments d'un contact à enfichage (174, 200).

46. Réseau d'alimentation électrique selon l'une des revendications 42 à 45, **caractérisé en ce que** les éléments de contact de puissance (172a, b) sont des éléments d'un contact à enfichage (172).

47. Réseau d'alimentation électrique selon l'une des revendications 42 à 46, **caractérisé en ce qu'**un élément de contact de puissance (172a, b) respectif et l'un des éléments de contact de surveillance (174a, b, 200a, b) sont agencés dans un élément de liaison à enfichage (170a), et l'autre élément de contact de puissance (172a, b) et l'autre des éléments de contact de surveillance (174a, b, 200a, b) sont agencés dans l'autre élément de liaison à enfichage (170b) d'un dispositif de liaison à enfichage (170).

48. Réseau d'alimentation électrique selon l'une des revendications 42 à 47, **caractérisé en ce que** le circuit de surveillance (48) surveille une liaison mécanique des éléments de liaison à enfichage (70a, 70b, 70'a, 70'b) et, lorsque la liaison mécanique est annulée, il interrompt un écoulement de courant à travers l'âme de ligne (20) conduisant le courant, au moyen d'une coupure (54).

49. Réseau d'alimentation électrique selon la revendication 48, **caractérisé en ce que** le circuit de surveillance (48) surveille un dispositif de verrouillage (180) des éléments de liaison à enfichage (70'a, 70'b).

50. Réseau d'alimentation électrique selon l'une des revendications précédentes, **caractérisé en ce que** le système de ligne de surveillance est formé par le système de ligne de détection (24).
